# EUROPÄISCHE PATENTSCHRIFT

(11) **EP 0 783 170 B1**
(45) Veröffentlichungstag und Bekanntmachung des Hinweises auf die Patenterteilung: **28.03.2001**
(21) Anmeldenummer: 96100070.0
(22) Anmeldetag: 04.01.1996
(51) Int. Cl.: G11C 29/00, G06F 11/22, G01R 31/28

(54) **Vorrichtung und Verfahren zur Erfassung und Bewertung eines räumlich diskreten Punktmusters**
Apparatus and method for the acquisition and analysis of a three-dimensional distribution of discrete points
Appareil et procédé pour l'acquisition et l'analyse d'une distribution spatiale de points discrets

(43) Veröffentlichungstag der Anmeldung: 09.07.1997
(73) Patentinhaber: Infineon Technologies AG, 81669 München (DE)
(72) Erfinder: Federl, Peter, D-93049 Regensburg (DE)
(74) Vertreter: Zedlitz, Peter, Dipl.-Inf.

(56) Entgegenhaltungen:
- EP-A- 0 447 995
- EP-A- 0 633 536
- IEEE INTERNATIONAL TEST CONFERENCE 1989, August 1989, WASHINGTON DC, USA, Seiten 431-438, XP000089972 MALZFELDT ET AL: "Fast Automatic Failbit Analysis for DRAMs"

## Beschreibung

Die Erfindung bezieht sich auf eine Vorrichtung und ein Verfahren zur Erfassung und Bewertung eines in einem mehrdimensionalen Koordinatensystem angeordneten räumlich diskreten Punktmusters, wobei jeder Punkt des Musters wenigstens zwei unterscheidbare Zustandswerte annimmt. Insbesondere bezieht sich die Erfindung auf eine Vorrichtung und ein Verfahren zur Erkennung und Klassifizierung der binären Ausfallmuster von defekten Speicherzellen eines Halbleiterspeichers.

Die Ausfallmuster der Speicherzellen von defekten Halbleiterspeichern geben Hinweise auf die den Ausfällen zugrunde liegenden Technologieprobleme bei der Herstellung der Halbleiterspeicher. Neben der möglichen rein statistischen Verteilung der Ausfallmuster auf einem Wafer, die in der Regel auf Partikelprobleme bei bestimmten Prozessen der Chipherstellung schließen läßt, geben insbesondere nichtstatistische Verteilungen der Ausfallmuster auf einem Wafer nach Auswertung geeignete Hinweise auf systematische Technologie- und Prozeßprobleme. Um auf einer statistisch ausreichenden Basis Aussagen über solche Probleme treffen zu können, ist es notwendig, die Ausfallmuster einzelner Halbleiterchips bzw. Verteilungen der Ausfallmuster über einen gesamten Siliziumwafer zu erkennen und zu klassifizieren. Eine Schwierigkeit besteht hierbei unter anderem darin, daß Ausfallmuster in verschiedensten und immer neuen Varianten auftreten können. Weiterhin sind die der Analyse zugrundeliegenden, vermittels Chiptestsystemen gewonnenen Rohdatenmengen enorm. Bei einem dynamischen Halbleiterspeicherchip mit einer Speichergröße von beispielsweise 4 Mega fallen bei Berücksichtigung von ausfallenden reinen Null-Zellen, reinen Eins-Zellen und der Veroderung von Null- und Eins-Zellen im ungünstigsten Fall 4 Megabit • 3 = 12 Megabit an Rohdaten an. Hieraus ergibt sich eine Zahl der theoretisch denkbaren Varianten von Ausfallmustern bei einem 4-Megabit-Speicher von 2⁴¹⁹⁴³⁰¹-1, eine Zahl mit rund 1,2 Millionen Stellen. Mit Hilfe von "Landkarten", sogenannten Bitmaps, welche Muster von nichtfunktionierenden Speicherzellen darstellen, wird versucht, diese nahezu unendlich große Zahl von Ausfallmustern zu ordnen. Obzwar aufgrund der Ähnlichkeit der gewonnenen Bitmaps eine Einteilung in etwa 80 bis 100 Ausfallklassen durchgeführt werden kann, werden bei einer manuellen Bewertung durch eine Bedienungsperson für die visuelle Fehleranalyse sämtlicher Ausfallmuster eines Wafers von typischerweise 6" Durchmesser etwa 15 Stunden benötigt. Es ist versucht worden, die Analyse der Ausfallmuster mit herkömmlichen Methoden durch einen Rechner zu automatisieren; die Ergebnisse stellten sich hingegen als äußerst unbefriedigend dar, da zum einen wichtige Fehlerklassen von Ausfallmustern rechnerisch nicht erfaßt werden und eine manuelle Nachbearbeitung durch einen geschulten Fachmann erfordern, und zum anderen die Analysezeiten bei den bisherigen Methoden auch unter Verwendung modernster Rechnermittel mit hohen Rechengeschwindigkeiten noch zu lang ausfallen, so daß eine Anwendung der bisher verwendeten Analyseverfahren namentlich auf größere Halbleiterspeicher mit 4 Mega und mehr wenig praktikabel ist. Bei dem bisher angewandten Verfahren wurden aufgrund der hohen Rechenzeit zur Analyse von Speicherchipausfallmustern einzelne Wafer bzw. Speicherchip-Bausteine der laufenden Produktion lediglich stichprobenweise entnommen und separat mit einem speziellen Analyseprogramm gemessen. Hierbei wurden nach einer Vorverarbeitung der Daten in einem speziell hierfür vorgesehenen Datenspeicher ("Fail Memory") der Meßvorrichtung die vorverarbeiteten Daten als Rohdatei von der Meßvorrichtung an einen Rechner übertragen und dort einer mit konventioneller Programmiertechnik erstellten Hauptanalyse unterzogen. Ein erheblicher Nachteil bestand bei dieser Vorgehensweise ferner darin, daß bei einem Übergang auf eine neue Speichergeneration erhebliche Teile der Vor- und Hauptanalyse neu programmiert werden mußten. Ebenso mußten neu zu analysierende Typen von Ausfallmustern mit großem Aufwand neu programmiert werden.

Aus EP-A-0 633 536 ist eine Vorrichtung zur Erfassung und Bewertung eines aus Testmessungen an einem Apparat gewonnenen Ausfallmusters seiner Komponenten bekannt, wobei diese Vorrichtung im einzelnen aufweist: eine Meßeinrichtung (1,2) zum Gewinnen und Speichern der Rohdaten; einen dem Speicher zugeordneten Rechner (3), in den die abgespeicherten Daten eingegeben werden, und in welchem ein Merkmalextraktor (features extraction) vorgesehen ist, der die Rohdaten nach bestimmten Merkmalen bearbeitet und das Ergebnis in einem Computing Vector ausgibt; ein dem Rechner zugeordnetes neuronales Netzwerk (4), in welches der Computing Vector als Eingabevektor eingegeben wird und welches durch Vergleichen des Eingabevektors mit Vorgabevektoren einen Ausgabevektor berechnet, und einen Klassifikationswert (diagnosis) des gemessenen Ausfallsmusters anhand des ermittelten Ausgabevektors zuordnet und ausgibt. Zur Arbeitsweise des Merkmalextraktors ist ausgeführt, daß er gemäß Hunderter von mathematischen Funktionen arbeiten könnte; eine Arbeitsweise als Koordinatenzähler ist jedoch nicht erwähnt.

Der Erfindung liegt die Aufgabe zugrunde, eine Vorrichtung und ein Verfahren zur Erfassung und Bewertung eines räumlich diskreten Punktmusters wie insbesondere eines Ausfallmusters eines Halbleiterspeicherchips zur Verfügung zu stellen, welche bzw. welches auch bei einer erheblichen Anzahl von Punkten, insbesondere im Bereich von größer als 1 Mega, eine selbsttätig und mit hoher Zuverlässigkeit und Reproduzierbarkeit durchzuführende Analyse und Klassifizierung des Punktmusters mit brauchbaren Analysezeiten ermöglicht.

Diese Aufgabe wird durch eine Vorrichtung gemäß Anspruch 1 und ein Verfahren gemäß Anspruch 5 gelöst.

Erfindungsgemäß ist vorgesehen, daß die Analyse des räumlich diskreten Punktmusters vermittels einem in einem Rechner implementierten neuronalen Netzwerk durchgeführt wird, dem ein n-dimensionaler Eingabevektor mit n Komponenten zur Analyse angeboten wird, und welches durch Vergleichen des Eingabevektors mit abgespeicherten, auf der Grundlage von Beispielpunktmustern gewonnenen Vorgabevektoren einen Ausgabevektor berechnet, der zur Klassifikation des Punktmusters einen Klassifikationswert des gemessenen Punktmusters anhand des ermittelten Ausgabevektors ausgibt.

Hierbei stellt das neuronale Netzwerk eine Anordnung von untereinander verknüpften Verarbeitungselementen dar, sogenannten Neuronen, welche in einer hierarchischen Struktur mit mehreren Ebenen angeordnet sind. Jedes Neuron kann einen oder mehrere Eingänge besitzen, und besitzt in der Regel nur einen Ausgang. Das vorzugsweise verwendete neuronale Netzwerk besteht aus drei unterschiedlichen Ebenen: eine dem Eingabevektor zugeordnete Eingabeebene, ein dem Ausgabevektor zugeordnete Ausgabeebene, und eine zwischen der Eingabeebene und der Ausgabeebene angeordnete, den Vorgabevektoren zugeordnete Rechenebene. Die Anzahl der Neuronen in der Berechnungsebene hängt hierbei unter anderem ab von der Komplexität des dem neuronalen Netzwerkes für die Erkennung präsentierten Punktmusters, der gewünschten Informationskapazität des Netzwerkes, der Anzahl und dem Ausmaß der Fähigkeiten des trainierten neuronalen Netzwerkes, unbekannte Muster zu bearbeiten, sowie der Anzahl von Iterationen, welche das neuronale Netzwerk in der Trainingsphase durchführt, um sämtliche gewünschten Netzwerkrichtungen und Basiswerte zur Verfügung zu stellen.

Bei der Betriebsweise des neuronalen Netzwerkes werden zwei nacheinander durchzuführende Prozeduren unterschieden: Zum einen das Training auf der Grundlage von Beispielpunktmustern mit bekannten Ausgängen, und zum anderen die eigentliche Erkennungsprozedur von unbekannten Mustern.

Beim Training des neuronalen Netzwerkes werden diesem aufeinanderfolgend vorbestimmte Eingabedatenmuster präsentiert, die sogenannten Beispielpunktmuster. Die Werte der neuronalen Basiswerte in dem neuronalen Netzwerk werden hierbei derart eingestellt, daß der Ausgang des Netzwerkes für jedes einzelne Trainingsmuster wenigstens ungefähr mit einem gewünschten entsprechenden Netzwerkausgang (Zielvektor bzw. Ausgabevektor) für das entsprechende Muster übereinstimmt. Nach der Vervollständigung des Trainings werden sämtliche Basiswerte bei ihren aktuellen Werten fixiert.

Daran anschließend kann das neuronale Netzwerk im Prinzip zur Erkennung von unbekannten Mustern verwendet werden. Bei der Mustererkennung werden die aus den unbekannten Punktmustern durch algorithmische Vorverarbeitung gewonnenen Eingabevektoren aufeinanderfolgend an die Eingänge des Netzwerkes angelegt, und entsprechend resultierende Netzwerkantworten von den Ausgabeknoten ausgegeben.

Bei einer bevorzugten Ausführung der Erfindung ist vorgesehen, daß das neuronale Netzwerk eine Anordnung vom Typ des Restricted Coulomb Energy-Netzwerkes aufweist. Der Name Restricted Coulomb Energy bezieht sich auf eine Energiefunktion auf der Grundlage eines elektrostatischen Potentiales. Die Bezeichnung RCE-Netzwerk ist markenrechtlich für die Firma Nestor geschützt, welches ein Unternehmen des Nobelpreisträgers L. N. Cooper ist. Ein neuronales Netzwerk vom RCE-Typ besitzt genau drei Ebenen, eine Eingabeebene("input layer"), eine Rechenebene ("hidden layer"), und eine Ausgabeebene ("output layer"). Die Rechenebene ist vollständig mit der Eingabeebene verbunden. Weiterhin ist die Ausgabeebene teilweise mit der Rechenebene verbunden. Der Grund hierfür liegt darin, daß unterschiedliche Arten von Verarbeitungselementen in den Rechen- und Ausgabeebenen verwendet werden. Im Vergleich zu neuronalen Netzwerken vom Kohonen-Typ oder Perzeptron-Typ arbeiten RCE-Netzwerke aufgrund ihrer einfacheren Anordnung sehr schnell und effizient. Das neuronale Netzwerk wird wie folgt trainiert. Zunächst wird bei diesem Typ der Eingabeebene des neuronalen Netzwerkes ein n-dimensionaler Eingabevektor, der aus einem Beispielpunktmuster einer bekannten Klasse durch Vorverarbeitung gewonnen wurde, präsentiert, wobei der Eingabevektor einen Zielpunkt in einem n-dimensionalen Raum darstellt. In der mit der Eingabeebene verknüpften Rechenebene des neuronalen RCE-Netzwerkes wird um den Zielpunkt jedes Eingabevektors ein n-dimensionaler Raumbereich (Hypersphäre oder Hyperquader) mit dem Zielpunkt des Eingabevektors als Mittelpunkt des n-dimensionalen Raumbereiches festgelegt, wobei das Volumen dieses Raumbereiches entsprechend der zuzuordnenden Klasse eingestellt wird. Sämtliche Raumpunkte innerhalb dieses n-dimensionalen Raumbereiches gehören somit zu der vorbestimmten, dem jeweiligen Beispielpunktmuster zugehörenden Klasse. Dieses Verfahren wird mit weiteren Eingabevektoren, die zu weiteren Klassen gehören, wiederholt. Nach der Präsentation dieser weiteren Eingabevektoren stellt das neuronale Netzwerk fest, ob ein zu einer bestimmten Klasse gehörender Eingabevektor innerhalb des Raumbereiches eines zu einer anderen Klasse gehörenden Eingabevektors liegt. Falls dies zutrifft, werden die entsprechenden Raumbereiche durch geometrische Anpassung bzw. Verjüngung soweit geändert, daß ein zu einer bestimmten Klasse gehörender Eingabevektor nicht innerhalb des Raumbereiches eines zu einer anderen Klasse gehörenden Eingabevektors zu liegen kommt, wobei es im übrigen durchaus möglich sein kann, daß sich einige der Raumbereiche, auch solche unterschiedlicher Klassen, bereichsweise überlappen. Vorzugsweise werden zur Ausbildung der n-dimensionalen Raumbereiche Hyperquader verwendet, was im Gegensatz zur Verwendung von Hypersphären als Raumbereiche einer bestimmten Klasse den Vorteil besitzt, daß im Falle einer Anpassung der Raumbereiche nicht jede Dimension verjüngt werden muß. Im Falle der Verwendung von Hypersphären ist die Volumenabnahme des Raumbereiches bei einer Verjüngung stets größer als bei Hyperquadern. Damit ist die Möglichkeit der Verallgemeinerung, welche eine wichtige Eigenschaft von neuronalen Netzwerken darstellt, ungünstiger als im Falle von Quadern.

Ein Vorteil von RCE-Netzwerken besteht weiterhin allgemein darin, daß diese automatisch während der Trainingsprozedur konfiguriert werden. Die Trainingsprozedur kombiniert die Konfiguration und das Lernen durch die Verwendung des führenden Algorithmus. Demzufolge wird die Anzahl der Recheneinheiten ("Hidden units") in der Rechenebene des neuronalen Netzwerkes automatisch festgelegt. Neben der Festlegung von neuen Beispielmustern kann durch die Trainingsprozedur die Größe bzw. Ausdehnung der Raumbereiche einfacher angepaßt werden.

Ein wesentliches Merkmal der Erfindung besteht darin, daß dem neuronalen Netz nicht die ursprünglichen, physikalisch gemessenen Koordinaten- und Zustandswerte jedes Punktes des mehrdimensionalen räumlichen Punktmusters angeboten werden, sondern es werden zunächst Koordinatenzähler bzw. Koordinatenprojektionen für jeden Koordinatenwert einer Koordinatenachse aus den ursprünglichen Daten berechnet, wobei der Wert des Koordinatenzählers aus der Anzahl der erfaßten Punkte des Punktmusters der entsprechenden Koordinate mit einem vorbestimmten Zustandswert berechnet wird. Die eigentliche Mustererkennung vermittels des neuronalen Netzes findet auf der Grundlage der ermittelten Koordinatenzähler statt. Auf diese Weise werden die bei der Aufzeichnung der Koordinatenwerte und Zustandswerte jedes Punktes vermittels der Meßeinrichtung anfallenden Rohdatenmengen erheblich komprimiert. Beispielsweise ergibt sich bei der Analyse der Ausfallmuster eines Halbleiterchips vom 4 Megabit-Typ anstelle der Rohdatenanzahl von 4 Megabit • 3 = 12 Megabit nurmehr eine Datenmenge von (1024 + 256) • 3 • 16 Datenworte zu 16 Bit, also knapp 1 Megabit. Somit wird bei diesem Beispiel nur der zwölfte Teil der Datenmenge im Vergleich zu einer vollständigen Übertragung der Punktmusterdaten von der Meßeinrichtung zum Rechner übertragen. Diese Reduktion der Datenmenge ist allerdings mit einem Verlust an Information verbunden, der insbesondere dann auftritt, wenn sich mehr als ein Zustandswert einer Koordinate, beispielsweise ein einzelner Punktdefekt (im Falle eines Halbleiterspeichers ein elektrischer Ausfall, bei dem sowohl die x- als auch die y-Koordinate im Prinzip bekannt ist) innerhalb eines bestimmten Bereiches des Punktmusters befindet. In solchen Fällen ist zwar der Fehlertypus (beispielsweise Wort-Bit-Leitungs-Kreuzung, Einzelbit, Cluster usw.) in der Regel eindeutig ermittelbar, jedoch nicht die genaue x- und y-Koordinate im physikalischen Block des Halbleiterspeichers. Bei Ausfällen, die entweder nur wort- oder nur bitleitungsorientiert sind, tritt dieses Problem allerdings nicht auf.

Dem Prinzip der Erfindung folgend werden zur weiteren Reduktion der Datenmenge dem neuronalen Netzwerk nicht etwa die Koordinatenzähler unmittelbar als Eingabevektoren präsentiert, sondern ein n-dimensionaler Eingabevektor, wobei die Anzahl n typischerweise in der Größenordnung von etwa 10 bis etwa 30 liegt, bei dem die n Komponenten des Eingabevektors durch eine Reihe von Unterprozeduren aus den Werten der Koordinatenzähler des räumlich diskreten Punktmusters gewonnen werden.

Insbesondere können den Komponenten des n-dimensionalen Eingabevektors folgende numerische Werte, die unmittelbar aus den Koordinatenzählern des räumlich diskreten Punktmusters abgeleitet sind, zugeordnet werden:
- eine Abweichung vom Schwerpunkt der Koordinatenzähler des räumlich diskreten Punktmusters von Punkten mit einem vorbestimmten Zustandswert in Richtung einer bestimmten Koordinatenachse, und/oder
- eine Maßzahl für eine globale monotone Verteilung von Teilbereichen des Punktmusters von Punkten mit einem vorbestimmten Zustandswert, und/oder
- eine Maßzahl für die Periodizität des Punktmusters von Punkten mit einem vorbestimmten Zustandswert, und/oder
- ein zweites Moment der Massenverteilung von Punkten des Punktmusters mit einem vorbestimmten Zustandswert, und/oder
- einen Anteil von Koordinatenzählern mit mehr als einer vorbestimmten Anzahl von Punkten des Punktmusters mit einem vorbestimmten Zustandswert, und/oder
- einen Anteil von Echopunkten von Punkten des Punktmusters mit einem vorbestimmten Zustandswert, und/oder
- eine Maßzahl der Fluktuationen von Punkten benachbarter Koordinatenzähler des Punktmusters mit einem vorbestimmten Zustandswert, und/oder
- einen Anteil von Koordinaten mit weniger als eine vorbestimmte Anzahl der entsprechenden Koordinate von Punkten des Punktmusters mit einem vorbestimmten Zustandswert, und/oder
- eine Äquidistanz von Punkten des Punktmusters mit einem vorbestimmten Zustandswert in einem periodischen Teilbereich des Punktmusters, und/oder
- eine Anzahl von zusammenhängenden oder wenigstens teilweise zusammenhängenden Teilbereichen von Punkten des Punktmusters mit einem vorbestimmten Zustandswert in vorbestimmten Koordinatenrichtungen.

Hierbei kann in vorteilhafter Weise vorgesehen sein, daß die den n Komponenten des n-dimensionalen Eingabevektors zugeordneten numerischen Werte normiert sind, insbesondere in dem numerischen Zahlenbereich zwischen -1 und +1.

Bei einer besonders bevorzugten Ausführung der Erfindung ist vorgesehen, daß das mehrdimensionale Koordinatensystem des räumlich diskreten Punktmusters orthogonale Koordinatenachsen, insbesondere zwei orthogonale Koordinatenachsen aufweist, und der Wert jedes Koordinatenzählers durch Aufsummierung der erfaßten Punkte jeder Koordinate mit einem vorbestimmten Zustandswert und Projektion auf die entsprechende orthogonale Koordinatenachse, insbesondere Spaltenachse und Reihenachse gebildet wird.

Bei einer besonders bevorzugten Anwendung der Erfindung ist vorgesehen, daß das Punktmuster das Ausfallmuster eines physikalisch zusammenhängenden Blockes von Speicherzellen eines Halbleiterspeichers aus einer Vielzahl auf der Hauptoberfläche eines Halbleiterwafers ausgebildeten Halbleiterspeichern darstellt. Hierbei besitzt jede Ausfallzelle des Ausfallmusters einen von drei Zustandswerten von denen ein Zustandswert einem Null-Ausfall der Speicherzelle, ein Zustandswert einem Eins-Ausfall der Speicherzelle und ein Zustandswert einem Null- und Eins-Ausfall der Speicherzelle zugeordnet ist. Hierbei sind die Speicherzellen des auf der Hauptoberfläche des Halbleiterwafers ausgebildeten Halbleiterspeichers in Bitleitungen bzw. Spalten und in Reihen bzw. Wortleitungen matrixförmig angeordnet, und die Koordinatenzähler stellen jeweils einen Spaltenzähler und einen Reihenzähler dar.

Von besonderem Vorteil werden bei dieser bevorzugten Anwendung der Erfindung den Komponenten des n-dimensionalen Eingabevektors folgende numerischen Werte zugeordnet:
- eine Abweichung vom Schwerpunkt von Ausfallzellen eines physikalischen Blockes des Halbleiterspeichers mit einem vorbestimmten Ausfallzustand in Bitleitungs- und/oder Wortleitungsrichtung; und/oder
- ein zweites Moment der Massenverteilung von Ausfallzellen eines physikalischen Blockes des Halbleiterspeichers mit einem vorbestimmten Ausfallzustand in Bitleitungs- und/oder Wortleitungsrichtung; und/oder
- eine Maßzahl der globalen monotonen Verteilung von Ausfallzellen eines physikalischen Blockes des Halbleiterspeichers mit einem vorbestimmten Ausfallzustand; und/oder
- eine Maßzahl für die Periodizität des Ausfallmusters von Ausfallzellen eines physikalischen Blockes des Halbleiterspeichers mit einem vorbestimmten Ausfallzustand, und/oder
- einen Anteil der Bitleitungen und/oder Wortleitungen von Ausfallzellen eines physikalischen Blockes des Halbleiterspeichers mit einem vorbestimmten Ausfallzustand mit mehr als einem vorgegebenen ersten Grenzwert auf der betroffenen Leitung; und/oder
   - einen Anteil von Bitleitungen und/oder Wortleitungen von Ausfallzellen eines physikalischen Blockes des Halbleiterspeichers mit einem vorbestimmten Ausfallzustand mit mehr als einem vorgegebenen zweiten Grenzwert auf der betroffenen Leitung, wobei die betroffenen Wort- und/oder Bitleitungen ein Echo in benachbarten physikalischen Blöcken aufweisen; und/oder
- eine Maßzahl für die Fluktuationen von Ausfallzellen eines physikalischen Blockes des Halbleiterspeichers mit einem vorbestimmten Ausfallzustand zwischen benachbarten Bitleitungen und/oder benachbarten Wortleitungen; und/oder
- einen Anteil von Bitleitungen und/oder Wortleitungen mit Ausfallzellen eines physikalischen Blockes des Halbleiterspeichers mit einem vorbestimmten Ausfallzustand mit weniger als einem dritten Grenzwert von Ausfallbits auf der betroffenen Wort- und/oder Bitleitung; und/oder
- eine Maßzahl für die Äquidistanz ausfallbehafteter Bitleitungen und/oder Wortleitungen mit einem periodischen Muster;
- eine Maßzahl für die Anzahl von größeren Gruppen von Ausfallzellen in Bitleitungs- und/oder Wortleitungsrichtung; und/oder
- einen Anteil von Bitleitungen und/oder Wortleitungen, welche Zwischenschichtkurzschlüsse in Bit- und/oder Wortleitungsrichtung aufweisen; und/oder
- die Gesamtzahl von Ausfallzellen; und/oder
- eine Maßzahl für am Randbereich des Wafers gehäuft auftretende Ausfallzellen; und/oder
- ein Verhältnis zwischen längeren ausfallbedingten Wort-und/oder Bitleitungen in Wortleitungs- und/oder Bitleitungsrichtung.

Die Erfindung ermöglicht durch den Einsatz eines neuronalen Netzwerkes eine zuverlässige Klassifikation von SpeicherchipAusfallmustern, welche auch parallel neben dem üblichen Funktionstest von Speicherchips während einer Standardproduktionsmessung durchgeführt werden kann. Der Vorverarbeitungsalgorhythmus zur Bereitstellung der Eingabedaten für das neuronale Netzwerk und das neuronale Netzwerk selbst sind skalierbar und ermöglicht damit den Einsatz der verwendeten Software bei einem Übergang von einer Chipgeneration zur nächsten, ohne daß diese neu programmiert werden müßte. Darüber hinaus können qualitativ neu auftretende Ausfallmuster durch einfaches Training, d.h. Lernen anhand eines Beispielmusters, auf einfache Weise berücksichtigt werden, ohne daß eine Änderung des im Rechner ablaufenden Programmes erforderlich ist. Zur Implementierung des Analyseprogramms kann ein kostengünstiger Rechner, beispielsweise ein handelsüblicher Personal Computer (PC) verwendet werden, der beispielsweise über eine Schnittstellenkarte mit dem Rechner bzw. dem Mikroprozessor des Chiptestsystems verbunden ist. Damit ist es auch möglich, durch paralleles Herausführen des Daten- und Adressbussystems, über welches der Mikroprozessor des Chiptestsystems mit dem Fail Memory des Testsystems kommuniziert, auf die Schnittstellenkarte des PC's das Ausfallmuster im Fail Memory parallel zu dessen Verarbeitung im Chiptestsystem in den separat angeordneten PC einzulesen und dort weiterzuverarbeiten. Im Gegensatz zur konventionellen Ausfallmusteranalyse erfolgt die Weiterverarbeitung hierbei nicht wie bisher durch algorhythmisches Zerlegen der Ausfallmuster mit konventioneller Programmiertechnik, sondern durch Extraktion charakteristischer Merkmale aus dem Ausfallmuster und Vorlage dieser Merkmale als Eingabevektor für ein neuronales Netzwerk, welches dann die Klassifizierung der Ausfallmuster übernimmt. Die Erfindung bietet hierbei auch den Vorteil, die eigentliche Mustererkennungsaufgabe nicht auf sehr teueren ChipTestsystemen durchzuführen, sondern auf im Vergleich dazu sehr kostengünstiger PC-Hardware. Demgegenüber können erfindungsgemäß die Chip-Testsysteme bzw. die Meßeinrichtung ausschließlich zur schnellen Rohdatenerfassung eingesetzt werden.

Weitere Merkmale, Vorteile und Zweckmäßigkeiten der Erfindung ergeben sich aus der Beschreibung eines bevorzugten Ausführungsbeispieles anhand der Zeichnung. Es zeigt:
- Figur 1: eine schematische Darstellung der erfindungsgemäßen Vorrichtung gemäß einem Ausführungsbeispiel;
- Figur 2: eine schematische Ansicht von Ausfallzellen in Draufsicht eines auf der Hauptoberfläche eines Siliziumwafers ausgebildeten Halbleiterspeichers, bei dem die Speicherzellen in Bitleitungen und Wortleitungen matrixförmig angeordnet sind;
- Figuren 3A bis 3F: schematische Ansichten der Koordinatenzähler von typischerweise vorkommenden Ausfallmustern der Speicherzellen eines physikalischen Blockes, wobei jeweils auf der rechten Teilansicht der Figuren die Bitleitungszähler, und auf der linken Teilansicht die Wortleitungszähler aufgetragen sind;
- Figur 4: ein Flußdiagramm zur Erläuterung des Verfahrensablaufes eines bevorzugten Ausführungsbeispieles der Erfindung;
- Figur 5: eine schematische Ansicht eines RCE-Netzwerkes mit drei Netzwerkebenen; Figur 6 eine Darstellung zur Erläuterung der prinzipiellen Arbeitsweise eines RCE-Netzwerkes anhand einer geometrischen Interpretation;
- Figur 7A und 7B: schematische Darstellungen zweier zweidimensionaler Eingabevektoren, wobei bei der Teilansicht 7A der erste Vektor nicht innerhalb des Raumbereiches des zweiten Vektors liegt, und bei der Teilansicht 7B der erste Vektor innerhalb des Raumbereiches des zweiten Vektors liegt und demzufolge eine Verjüngung wenigstens eines Raumbereiches erforderlich ist;
- Figur 8: ein schematisches Balkendiagramm als Ergebnis einer Bewertung von auf einem Wafer vorkommenden Klassen von Ausfallmustern.

In den Figuren ist ein bevorzugtes Ausführungsbeispiel der Erfindung dargestellt, bei dem die Ausfallmuster der Speicherzellen eines defekten dynamischen Halbleiterspeichers vom Typ 4 Mega untersucht werden. Selbstverständlich ist die Erfindung ohne weiteres zur Analyse von größeren Halbleiterspeichern, beispielsweise 16 Mega, 256 Mega und mehr möglich; auf soweit erforderliche Besonderheiten wird an einigen Stellen der nachfolgenden Beschreibung gesondert eingegangen.

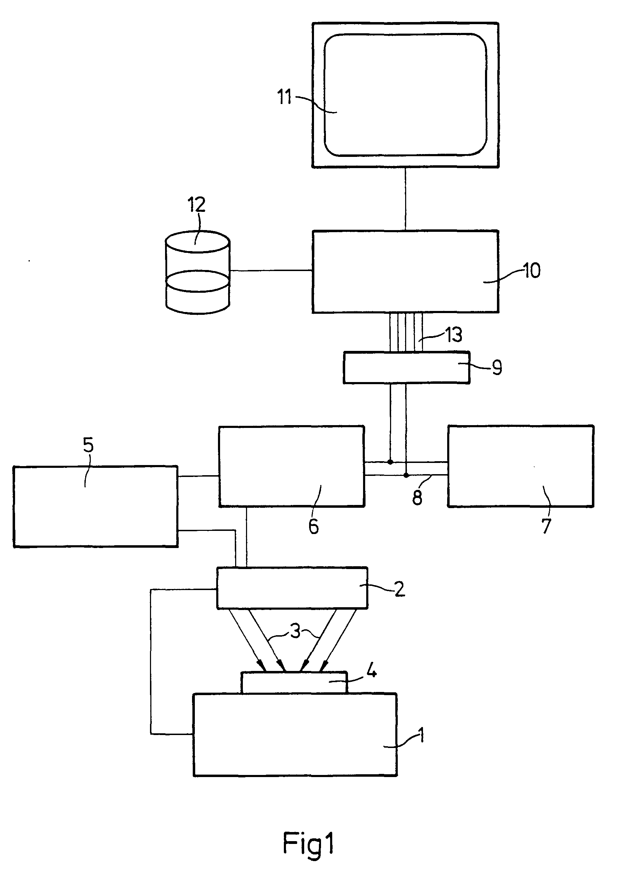

Das dargestellte Ausführungsbeispiel entspricht einem automatisierten Mustererkennungssystem, wie es in der Megabit-Chipfertigung eingesetzt wird. Figur 1 zeigt in einer schematischen Ansicht nähere Einzelheiten des Mustererkennungssystems gemäß Erfindung. Es ist ein programmierbarer Waferprober 1 und eine diesem zugeordnete Messondeneinrichtung 2 mit Messpitzen 3 als Bestandteile eines automatischen parametrischen Chiptestsystems zur Messung der auf einem Wafer 4 gefertigten DRAM-Speicherbausteine vorgesehen. An die Messeinrichtung angeschlossen sind eine Vielzahl von Messinstrumenten 5 zur Erfassung und Auswertung der elektrischen Eigenschaften der auf dem Wafer 4 angeordneten Speicherbausteine. Zur Steuerung der einzelnen Bestandteile der Messeinrichtung ist ein Steuerprozessor 6 vorgesehen, dem zur Abspeicherung und Vorverarbeitung der Daten ein Fail Memory 7 zugeordnet ist. Der Steuerprozessor 6 der Meßeinrichtung kommuniziert mit dem Fail Memory 7 über einen Daten- und Adressbus 8, an den eine Schnittstellenkarte 9 angeschlossen ist, über die die Rohdaten aus dem Fail Memory 7 über Leitungen 13 in einen separaten Rechner 10 zur Weiterverarbeitung eingelesen werden. Die Weiterverarbeitung der in den Rechner 10 eingelesenen Rohdaten erfolgt nicht wie bisher durch algorhythmisches Zerlegen der gemessenen Ausfallmuster mit konventioneller Programmiertechnik, sondern durch Extraktion charakteristischer Merkmale aus dem Ausfallmuster und Vorlage dieser Merkmale als Eingabevektor für ein innerhalb des Rechners 10 ausgebildetes neuronales Netzwerk, welches anschließend die Klassifizierung der eingegebenen Ausfallmuster übernimmt, wie nachstehend näher erläutert wird. Dem Rechner 10 ist eine Anzeigeeinrichtung wie beispielsweise ein Bildschirm 11 zugeordnet, auf dem das vermittels des Rechners 10 analysierte Ausfallmuster und das Ergebnis der Klassifikation angezeigt werden kann. Dem Rechner 10 ist ferner ein Datenspeicher 12 zur Ablage der Rohdaten und der verarbeiteten Daten zugeordnet.

Das Verfahren gemäß Ausführungsbeispiel kann grob in vier Funktionseinheiten unterteilt werden:
1. Messung der Halbleiterchips eines Wafers, Verarbeitung der Meßdaten, Einlesen der gemessenen Rohdaten als Rohdatendatei in einen Rechner, und Aufbereiten der Rohdaten zur weiteren Analyse.
2. Durchführen einer ersten Analyse eines fehlerbehafteten physikalischen Blockes hinsichtlich massereicher Fehler.
3. Durchführen einer zweiten Analyse eines fehlerbehafteten physikalischen Blockes hinsichtlich Fehler mit geringer Fehlermasse.
4. Überprüfen, ob signifikante Verteilungen einzelner Fehlerklassen auf bestimmten Waferbereichen vorliegen und gleichzeitiges Erstellen einer Ergebnisdatei.

Im folgenden werden die vier Funktionseinheiten näher erläutert.

Zu 1. Messung der Halbleiterchips eines Wafers, Verarbeitung der Meßdaten, Einlesen der gemessenen Rohdaten, und Aufbereiten der Rohdaten zur weiteren Analyse.

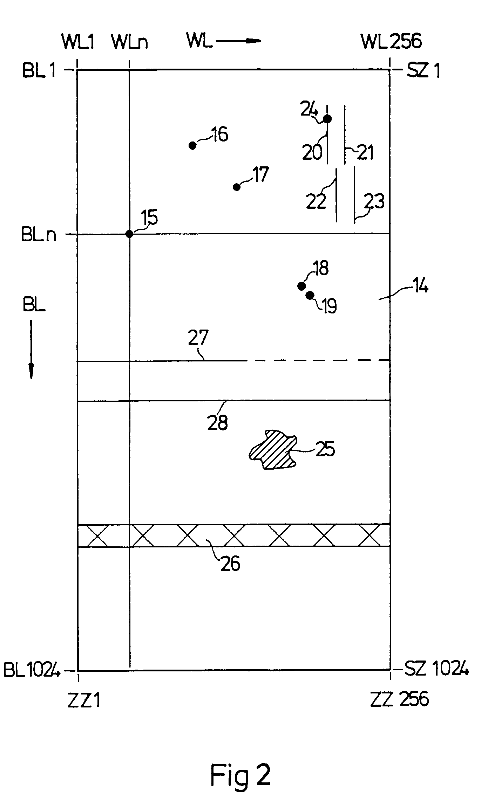

Bei der Messung der Chipausfälle vermittels der Meßeinrichtung bestehend aus dem Prober 1, Meßsondeneinrichtung 2 mit Meßspitzen 3, Meßinstrumenten 5, sowie Prozessor 6 und Fail Memory 7 werden zunächst von sämtlichen Halbleiterspeicherchips des 6"-Halbleiterwafers 2 die x- und y-Koordinaten jedes einzelnen Chips auf dem Wafer 2, sowie Informationen über Strom-Spannungswerte der Chips (beispielsweise Pass/Fail-Information über einen Operations- bzw. Stand-by-Strom, Generatorspannungen und dergleichen) vermittels der Meßeinrichtung bestimmt und für jeden Chip das Ausfallmuster und die Ausfallquote, d.h. der Anteil der insgesamt vorhandenen Ausfallzellen gemessen. Bereits bei der Messung bzw. Voranalyse der Ausfallmuster eines Halbleiterchips vermittels der Meßeinrichtung wird jeder Chip in physikalisch zusammenhängende Blöcke, welche beim 4 Mega-Speicher auch als Hexadekanten bezeichnet werden, unterteilt, so daß die eigentliche Musteranalyse in dieser physikalischen Untereinheit durchgeführt wird. Somit erfolgt die Analyse beim 4 Megabit-Speicherchip hexadekantenweise. Figur 2 zeigt eine schematische Draufsicht eines physikalischen Blockes 14 eines Halbleiterspeicherchips mit 256 Wortleitungen WL1 bis WL256 und 1024 Bitleitungen BL1 bis BL1024. Die Speicherzellen der Chips sind hierbei jeweils an Kreuzungsstellen einer Wortleitung WLn und einer Bitleitung BLm angeordnet. Ein physikalischer Block 14 besitzt somit eine Anzahl von 256 • 1024 = 262 144 Speicherzellen. In Figur 2 sind einige typisch vorkommende Anordnungen von fehlerhaften Speicherzellen dargestellt. Beispielsweise bezeichnen die Bezugsziffern 15, 16, 17 an der zugehörenden Wort-Bit-Leitungskreuzung einzeln ausgefallene Einzelzellen (Einzelbitausfälle), die Bezugsziffern 18 und 19 unmittelbar benachbart liegende ausfallende Einzelzellen (paarweiser Bitausfall), die Bezugsziffern 20, 21, 22, 23 nebeneinander auf einem Teil einer Wortleitung ausgefallene Speicherzellen, wobei bei dem Wortleitungsausfall 20 zusätzlich noch ein gesonderter Einzelausfall 24 mit einem anderen Ausfallzustand als bei den übrigen Ausfallzellen dieser Wortleitung 20 dargestellt ist, die Bezugsziffer 25 bezeichnet eine Anhäufung nebeneinanderliegender Ausfallzellen (sogenannte Cluster), die Bezugsziffer 26 einen Ausfall mehrerer nebeneinanderliegender Bitleitungen, und die Bezugsziffern 27 und 28 Ausfälle von Speicherzellen in einem zusammenhängenden Teil einer Bitleitung oder der vollständigen Bitleitung.

Die von der Meßeinrichtung bzw. dem Chiptestsystem erzeugte binäre Rohdatei mit Informationen für einen Wafer bzw. bei Bausteinmessungen für ein Los, d.h. einer produktionsbedingt zusammengehörenden Gruppe mehrerer gleichartiger Wafer wird als Rohdatendatei über die Leitungen 13 (siehe Figur 1) in den Rechner 10 eingelesen. Am Dateianfang der Rohdatendatei stehen Kopfinformationen wie Losnummer, Wafernummer und zugeordneter Designtyp. Sodann folgen in der Reihenfolge der gemessenen Halbleiterchips die Chipinformationen. Eine Chipinformation besteht aus einem Chipinfoblock, gefolgt von 16 Hexadekanten-Informationen (so beim 4 Mega-Halbleiterchip) bzw. 512 Segment-Informationen (so beim 16 Mega-Halbleiterspeicher). Der Chipinfoblock zeigt an, daß nun die Daten für einen bestimmten Chip folgen, namentlich die x-und y-Koordinaten des Chips auf dem Wafer, sowie technische Informationen, beispielsweise Informationen über Strom-Spannungswerte des Chips. Eine Hexadekanten-Information zeigt an, daß nun die Daten für einen neuen Hexadekanten folgen, und zwar die Hexadekanten-Nummer (beim 4 Mega-Halbleiterspeicher) bzw. die Segment-Nummer (beim 16 Mega-Halbleiterspeicher), und daran anschließend eine Anzahl von 256 Wortleitungszählern bzw. Spaltenzählern und 1024 Bitleitungszählern bzw. Zeilenzählern für den Gesamtausfall, und eine entsprechende Anzahl von Koordinatenzählern für Nullausfälle und Einsausfälle. Bei der bisherigen Analyse der Ausfallmuster eines Chips wurden sämtliche x- und y-Koordinaten der Ausfallzellen und der zugrundeliegende Ausfallzustand ermittelt. Demgegenüber werden bei der Erfindung für jeden physikalischen Block 1 des Halbleiterchips eine Anzahl von 256 Zeilenzählern ZZ1 bis ZZ256 und eine Anzahl von 1024 Spaltenzählern SZ1 bis SZ1024 ermittelt, von denen jeder als Information neben der Nummer der zugeordneten Zeile 1 bis 256 bzw. Spalte 1 bis 1024 die Anzahl der auf dieser Zeile bzw. Spalte insgesamt vorkommenden Ausfallzellen für jeden der drei Ausfallzustände umfaßt. Die Koordinatenzähler geben somit die auf die Koordinate projezierten Summenwerte aller Ausfälle mit einem bestimmten Ausfallzustand (d.h. '0', '1', oder '0' und '1') der zugeordneten Leitung wieder ("Projektion"). Im vorliegenden Fall ergibt sich daher für jeden zu analysierenden 4 Mega-Halbleiterchip mit 256 Zeilenzählern und 1024 Spaltenzählern pro Hexadekanten eine Gesamtdatenmenge bei im schlimmsten Falle 16 fehlerbehafteten physikalischen Blöcken zu (1024 + 256) • 3 • 16 Datenworte mit 16 Bit, also knapp 1 Megabit. Im Falle der Analyse eines 16 Mega-Halbleiterspeichers wird das gesamte Zellenfeld in 512 Segmente zu je 32 k (256 Wortleitungszähler und 128 Bitleitungszähler) unterteilt, die in einem weiteren Verarbeitungsschritt zu 192 physikalisch sinnvollen Blöcken rekombiniert werden.

Aufgrund der Organisation und der Adressierung des 4 Mega-Speicherchips ist es möglich, daß ausfallende Leitungen in einem vorbestimmten Hexadekanten in einem gleichzeitig ausgewählten zweiten Hexadekanten desselben Chips zusätzliche Ausfälle, sogenannte Echos, auf der gleichen Adresse des Chips zur Folge haben. Dabei sind die Bitleitungsadressen innerhalb beider betroffener Hexadekanten identisch, während die Wortleitungsadressen gespiegelt ausfallen, d.h. die Wortleitung WL 1 im ungeraden Hexadekanten korrespondiert mit der Wortleitung WL 256 im darauffolgenden geraden Hexadekanten. Um solche Fehler mit Echo zu erkennen, werden die Daten der jeweils zwei korrespondierenden Hexadekanten gemeinsam in global deklarierte Datenstrukturen eingelesen und aufbereitet.

Die wichtigsten globalen, d.h. auf einen gesamten Wafer bezogenen Datenstrukturen sind die folgenden dynamisch angelegten Arrays. Sie können für den 4 Mega-Halbleiterspeicher direkt aus den Hexadekanten-Informationen der Rohdatendatei übernommen werden, während sie für den 16 Mega-Halbleiterspeicher aus den Segmentinformationen - entsprechend modifiziert - zusammengestellt werden. Die folgenden Erläuterungen beziehen sich jeweils auf den 4 Megabit-Chip, gelten allerdings sinngemäß auch für einen 16 Megabit-Halbleiterspeicher. Zur Anpassung des erfindungsgemäßen Analyseverfahrens auf Chipgenerationen größer oder kleiner 4 Megabit bedarf es im wesentlichen lediglich der Änderung einiger globaler Konstanten, die in einer vorbestimmten Programmeinheit definiert sind, sowie der Anpassung der Programmeinheit zur Generierung der physikalischen Blöcke aus den Spalten- und Zeilenzählern der Rohdatendatei.

Die Rohdatendatei enthält somit unter anderem folgende Informationen:
- 256 Zeilenzähler des ungeraden Hexadekanten für Totalausfall,
- 256 Zeilenzähler des geraden Hexadekanten für Totalausfall,
- 1024 Spaltenzähler des ungeraden Hexadekanten für Totalausfall,
- 1024 Spaltenzähler des geraden Hexadekanten für Totalausfall,
- Ableitungen der als Funktionen aufgefaßten obigen Datenstrukturen, bei denen es sich ebenfalls um dynamisch angelegte Arrays handelt,
- Zusatzinformationen für die einzelnen Elemente der jeweiligen Spaltenzähler und Zeilenzähler, welche beispielsweise in einem dynamisch angelegten zweidimensionalen boolschen Array abgelegt sind. Diese Zusatzinformation beinhaltet beispielsweise folgende Flag-Signale:
   - flg[x,1] = true bedeutet: Leitung x fällt sowohl als '1' als auch als '0' aus;
   - flg[x,2] = true bedeutet: Leitung x fällt dominant mit '0' aus;
   - flg[x,3] = true bedeutet: Leitung x fällt dominant mit '1' aus;
   - flg[x,4] = true bedeutet: Leitung x besitzt einen 4 M-spezifischen Poly2-Poly3-Kurzschluß;
   - flg[x,5] = true bedeutet: Leitung x besitzt im korrespondierenden Hexadekanten ein Echo.

Echos werden hierbei nur dann gesucht, wenn der jeweils korrespondierende Hexadekant kein Totalausfall ist, denn dann hätte jede ausfallende Wortleitungs- und Bitleitungsprojektion im anderen Hexadekanten automatisch ein Echo, beziehungsweise wenn die jeweiligen Ausfallmuster nicht allzu chaotischen Charakter aufweisen. Wird eine Leitung im korrespondierenden Hexadekanten als Echo erkannt, so wird die Leitung aus den zentralen Datenstrukturen eliminiert und es wird das Flagsignal flg [x, 5] derjenigen Leitung, die verursachend für das Echo ist, auf einen Wert 'true'gesetzt. Bei der Leitungselimination sollte berücksichtigt werden, daß beispielsweise eine ausfallende Bitleitung in der Wortleitungs-Projektion auf jedes Array-Element der Zeilenzähler der geraden und ungeraden Hexadekanten mit dem Wert Eins projeziert wird. Daher sollte nicht nur alleine die Echo-Projektion in Bitleitungsrichtung eliminiert werden, sondern es sollten im Echo-Hexadekanten zusätzlich die 256 Projektionen mit dem Wert Eins auf die Wortleitungs-Projektion eliminiert werden. Entsprechendes gilt für ausfallende Wortleitungen. Da prinzipiell jede ausfallende Leitung beispielsweise in der Bitleitungsrichtung gleichzeitig in der anderen Projektion, d.h. Wortleitungs-Projektion, eine sogenannte Basislinie bewirkt, ist beim Eliminationsverfahren die Kenntnis der Basislinienbreiten in den beiden Projektionsrichtungen Voraussetzung. Die Basislinienbreiten werden vor jeder Elimination bestimmt. Eliminationen von Leitungen erfolgen nur bis zur gerade aktuellen Basislinie. Die vorstehend angestellten Betrachtungen zum Echo-Problem entfallen, falls - bedingt beispielsweise durch den Chip-Entwurf - keine Echos auftreten können, oder eine Berücksichtigung von Echos aus anderen Gründen nicht gewünscht oder erforderlich ist.

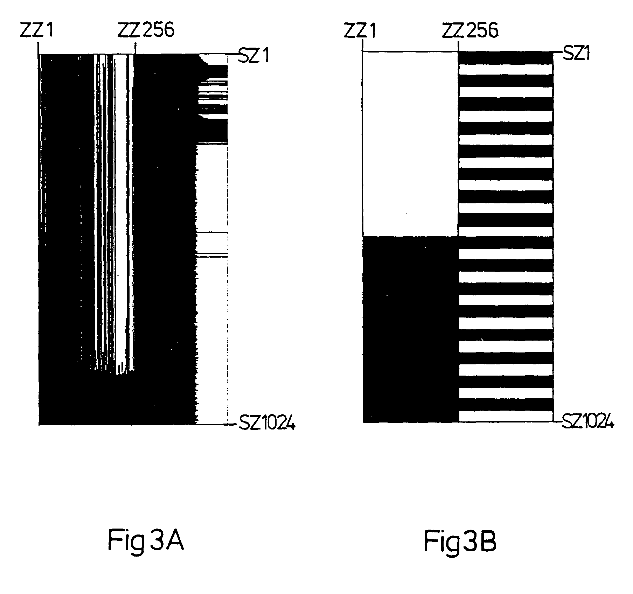

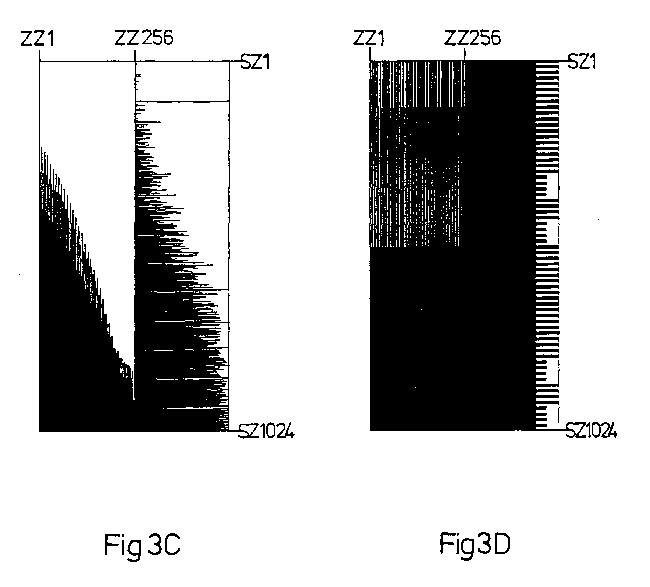

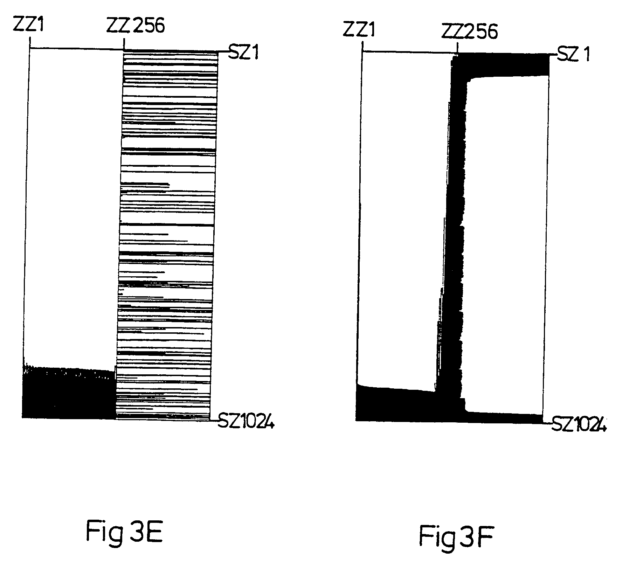

In den Figuren 3A bis 3F sind typische Beispiele vorkommender "massereicher" Ausfallmuster eines physikalischen Blockes dargestellt, und zwar besteht jede Figur aus zwei Hälften, wobei in der rechten Hälfte nach rechts jeweils die Werte der Spaltenzähler von SZ 1 bis SZ 1024 nach rechts, und auf der linken Bildhälfte die Werte der Zeilenzähler von ZZ 1 bis ZZ 256 nach oben aufgetragen sind. Figur 3A zeigt hierbei ein typisches Ausfallmuster mit vielen Zwischenschichtkurzschlüssen, welches der Klasse MILS zuzuordnen ist (MILS = Many Inter Layer Shorts), die Figur 3B zeigt ein Ausfallmuster mit periodisch regelmäßig beabstandeten Bitleitungsausfällen der Klasse BSDP (= Bitline Same Distance Period), Figur 3C zeigt ein Ausfal'lmuster mit einem eine gewisse Monotonie aufweisenden Bitleitungschaos der Klasse BCM (= Bitline Chaos with Monotony), die Figur 3D zeigt ein Ausfallmuster mit einem regelmäßigen Verlauf der Wortleitungs- bzw. Bitleitungsausfälle der Klasse WMBM (= Wordline Muster/Bitline Muster), die Figur 3E zeigt ein typisches Ausfallmuster mit einem Bitleitungschaos der Klasse BC (= Bitline Chaos), und Figur 3F zeigt ein typisches Ausfallmuster mit massiven Randfehlern der Klasse MRF (= massiver Randfehler). Die dargestellten typischen Ausfallmuster stellen einen Teil der verwendeten Klassen zur Beurteilung der Ausfallmechanismen dar; tatsächlich beträgt die Anzahl solcher Klassen typischerweise etwa 70 oder mehr.

Nach der vorstehend beschriebenen Aufbereitung der Rohdaten wird mit der eigentlichen Musterklassifikation begonnen. Hierbei werden in Abhängigkeit der gemessenen Ausfallquote eines Halbleiterchips zwei unterschiedliche Analyseverfahren eingesetzt: ein erstes neuronales Netzwerk NN1 für die Analyse eines fehlerbehafteten physikalischen Blockes hinsichtlich massereicher Fehler, und ein zweites neuronales Netzwerk NN2 für die Analyse eines fehlerbehafteten physikalischen Blockes hinsichtlich Fehler mit geringer Fehlermasse. Die Verwendung unterschiedlicher Verfahren in Abhängigkeit der eingangs gemessenen Ausfallquote wird im Hinblick auf die Geschwindigkeit der Analyse bzw. Optimierung der ermittelten Klassifikationsergebnisse vorgenommen. Hierbei ist zu berücksichtigen, daß die Verwendung eines neuronalen Netzwerkes insbesondere bei großen Datenmengen den Vorteil einer erheblich größeren Rechengeschwindigkeit bietet, jedoch mit einem erheblichen Informationsverlust verbunden ist. Auf der anderen Seite wird bei dem automatischen Mustererkennungsverfahren mit herkömmlichen Methoden eine lange Rechenzeit beziehungsweise hohe Belegungsrate des Rechners benötigt, es können jedoch wiederum mehr Informationen erhalten werden.

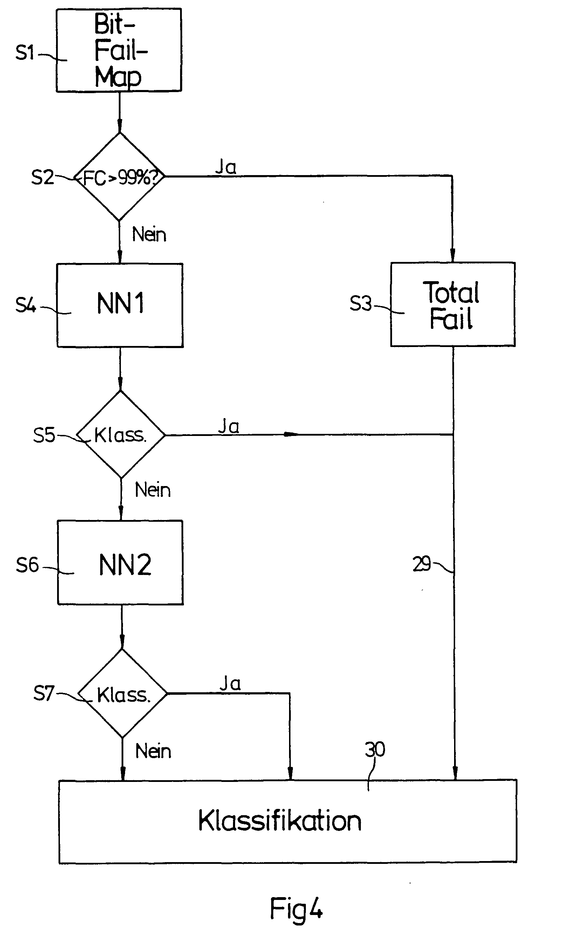

Anhand dem schematischen Flußdiagramm gemäß Figur 4 wird zunächst das Verfahren zur Analyse der gemessenen Ausfallmuster unter Verwendung der zwei unterschiedlichen Verfahren erläutert.

Gemäß Figur 4 werden bei einem Schritt S1 zunächst sämtliche von der Meßeinrichtung erhaltenen Rohdaten in den Rechner 10 eingegeben und die Ausfallquote FC ("Fail Count") des Verhältnisses der defekten Speicherzellen zur Gesamtanzahl berechnet. Falls sich die Ausfallquote FC bei dem Schritt S2 als größer als etwa 99 % bestimmt, wird bei einem Schritt S3 ein Totalausfall des Halbleiterchips angenommen und das Verfahren geht über den Zweig 29 unmittelbar an einen Ergebnisabschnitt 30 des Hauptprogrammes. Falls die Ausfallquote FC beim Schritt S2 kleiner als zu 99 % bestimmt wird, verzweigt das Programm an den Schritt S4, bei dem unter Verwendung des ersten neuronalen Netzwerkes NN1 eine Analyse der Ausfallmuster und Klassifizierung durchgeführt wird. Falls die Klassifizierung gelingt, geht das Verfahren über den Zweig 29 unmittelbar weiter an den Abschnitt 30 des Hauptprogrammes. Falls bei dem Schritt S5 eine Klassifizierung nicht möglich ist, wird in einem weiteren Zweig nochmals eine Feinanalyse durchgeführt; und zwar wird beim Schritt S6 eine Analyse und Klassifizierung des Ausfallmusters unter Verwendung eines zweiten neuronalen Netzwerkes NN2 durchgeführt. Falls eine Klassifizierung der Ausfallmuster gelingt, geht das Verfahren an den Abschnitt 30 des Hauptprogrammes an, bei dem die ermittelte Kategorie des Ausfallmusters ausgegeben wird. Falls eine Klassifizierung nicht gelingt, wird dies beim Schritt S7 bestimmt und im Abschnitt 30 eine nichtklassifizierbare Kategorie ausgegeben.

Zu 2. Erste Analyse eines fehlerbehafteten physikalischen Blockes hinsichtlich massereicher Fehler vermittels eines ersten neuronalen Netzes.

Nach der Aufbereitung der Rohdaten wird zunächst versucht, grobe Defekte zu klassifizieren. Unter groben Defekten werden massive Ausfälle des Zellenfeldes mit großen Fehlermassen im physikalischen Block verstanden. Dieser Teil der Mustererkennung wird mit Hilfe eines trainierten, ersten neuronalen Netzes NN1 realisiert. Dabei werden dem ersten neuronalen Netz NN1 nicht etwa die 256 Zeilen- und 1024 Spaltenzähler unmittelbar als Eingabevektor präsentiert, sondern ein beispielsweise 27-dimensionaler Eingabevektor, dessen Komponenten durch eine Reihe von Unterprozeduren unmittelbar aus den Koordinatenzählern - nur aus diesen - gewonnen werden. Die 27 Komponenten des Eingabevektors umfassen folgende Werte, die in dem numerischen Bereich von
-1 bis +1 normalisiert sind:
- bl, wl:: Anteil der Leitungen mit mehr als einem vorbestimmten Anteil, beispielsweise 90 % Ausfallbits auf der entsprechenden Leitung;
- echo_bl, echo_wl:: Anteil der Leitungen mit mehr als 90 % Ausfallbits auf der Leitung; Leitungen müssen hierbei Echos in korrespondierenden physikalischen Blöcken aufweisen.
- cm_bl, cm_wl:: Abweichung vom Schwerpunkt in Bitleitungs-, Wortleitungsrichtung; der Wert tendiert nach -1, falls sich die meisten Ausfalleitungen bei dem Beginn des physikalischen Blockes befinden, +1, falls sich die meisten Ausfalleitungen bei dem Ende des physikalischen Blockes befinden, 0, falls sich die meisten Ausfalleitungen in der Nähe der Mitte des physikalischen Blockes befinden.
- fl_bl, fl_wl:: Maßzahl für die Fluktuationen zwischen benachbarten Leitungen; tendiert nach +1, falls das Ausfallmuster chaotisch ist und viele Leitungen direkt benachbart zueinander sind.
- kz_bl, kz_wl:: Anteil der Leitungen mit weniger als 85 % Ausfallbits auf der Leitung.
- mon_bl, mon_wl:: Maßzahl für eine globale monotone Verteilung von Zellen in dem Ausfallmuster; tendiert nach -1, falls die Anzahl von Ausfallbits vom Beginn eines physikalischen Blockes zum Ende des Blockes abfällt, +1, falls die Anzahl der Ausfallbits vom Beginn eines physikalischen Blockes zum Ende des Blockes ansteigt.
- per_bl, per_wl:: Maßzahl für die Periodizität des Ausfallmusters; tendiert nach +1, falls das Muster periodisch ist und wenig chaotisch ist.
- pure_bl, pure_wl:: Maßzahl für die Äquidistanz der Ausfalleitungen in einem periodischen Muster; tendiert nach 0, falls die Periodizität nicht äquidistant ist, +1, falls die Periodizität äquidistant ist.
- si_bl, si_wl:: zweites Moment der Massenverteilung; unabhängig davon, ob Ausfalleitungen rechts oder links bezüglich der Mitte eines physikalischen Blockes angeordnet sind, tendiert diese Maßzahl nach +1, falls sich die meisten Ausfälle bei den Rändern des physikalischen Blockes befinden, 0, falls sich die meisten Ausfälle in der Nähe der Mitte des physikalischen Blockes befinden, 0.1, falls Ausfälle innerhalb des physikalischen Blockes gleichmäßig verteilt sind.
- more_bl, more_wl:: Maßzahl für die Anzahl von größeren Gruppen in Bitleitungs-, Wortleitungsrichtung; für jede größere Gruppe wird der Wert um 0.1 erhöht.
- p32:: Anteil der Leitungen, welche zwischen Lagen Kurzschlüssen in Bitleitungsrichtung anzeigen.
- mg_tot, mg_cmp:: Gesamtmasse von Ausfallzellen und deren Komplement.
- mrf:: Maßzahl für ein sogenanntes poliertes Muster; tendiert in Abhängigkeit der Form des Musters nach +1 oder -1.
- wl/bl:: Verhältnis zwischen längeren Ausfalleitungen (größer 90 % Ausfallbits) in Wortleitungs- und Bitleitungsrichtung; tendiert nach
-1, falls mehr längere Leitungen in Wortleitungsrichtung vorhanden sind,
+1, falls mehr längere Leitungen in Bitleitungsrichtung vorhanden sind.

Bei einem tatsächlich gemessenen Ausfallmuster eines physikalischen Blockes stellen sich die aufgrund der berechneten Spalten- und Zeilenzähler ergebenden Komponenten des Eingabevektors für das erste neuronale Netzwerk beispielhaft wie folgt dar:

| | |
|---|---|
| bl = 0.000 | wl = 0.000 |
| echo_bl = 0.000 | echo_wl = 0.000 |
| cm_bl = 0.095 | cm_wl = 0.695 |
| fl_bl = 0.019 | fl_wl = 0.019 |
| kz_bl = 1.000 | kz_wl = 1.000 |
| mon_bl = 0.281 | mon_wl = 0.531 |
| per_bl = 0.000 | per_wl = 0.000 |
| pure_bl = 0.000 | pure_wl = 0.000 |
| si_bl = 0.496 | si_wl = 0.705 |
| more_bl = 0.000 | more_wl = 0.000 |
| p32 = 0.000 | |
| mg_tot = 0.041 | mg_cmp = 0.959 |
| mrf = 0.071 | wl/bl = 0.000 |

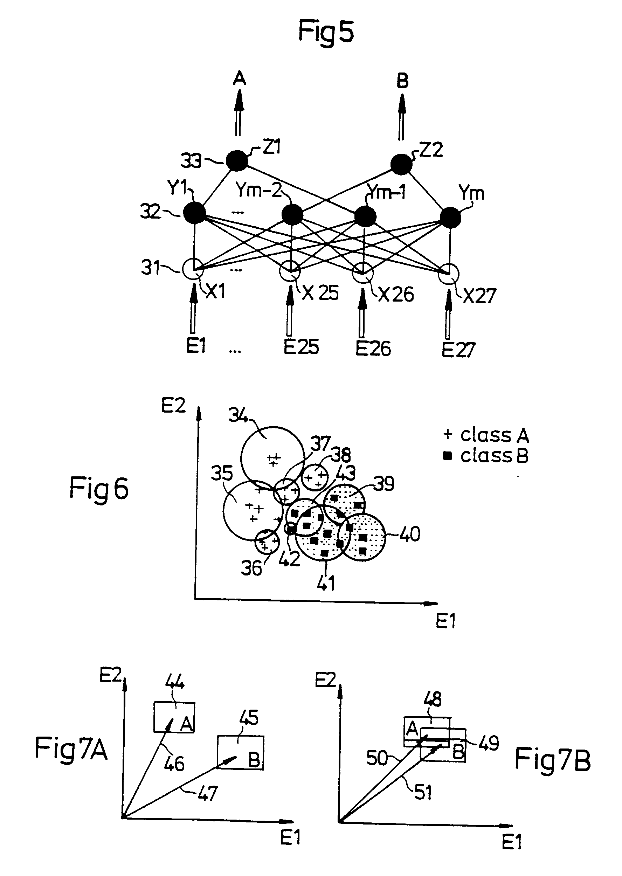

Das erste neuronale Netzwerk NN1 entscheidet nach Vorlage dieses Eingabevektors, um welche Fehlerklasse es sich bei dem Ausfall handelt bzw. gibt den Ausfall zur weiteren Bearbeitung frei, falls keine massive Fehlerklasse erfolgt. Als erstes neuronales Netzwerk NN1 wird hierbei eine Anordnung vom RCE-Typ verwendet, dessen prinzipielle Arbeitsweise schematisch anhand einer geometrischen Interpretation gemäß den Figuren 5 und 6, sowie den Figuren 7A und 7B erläutert wird.

Das in dem Rechner 10 implementierte neuronale Netzwerk NN1 vom RCE-Typ besitzt gemäß Figur 5 drei Ebenen, eine Eingabeebene 31, eine Rechenebene 32, und eine Ausgabeebene 33. Die Eingabeebene 31 weist eine Anzahl von 27 Verarbeitungselementen X1 bis X27 auf, von denen jede einer Komponente E1 bis E27 des 27-dimensionalen Eingabevektors zugeordnet ist. Den Verarbeitungselementen X1 bis X27 der Eingabeebene 31 ist eine Vielzahl von Verarbeitungselementen Y1 bis Ym der Rechenebene 32 zugeordnet, wobei die Anzahl m der Verarbeitungselemente Y der Rechenebene 32 in der Regel wesentlich größer ist als die Dimension n des Eingabevektors, und beispielsweise von der Komplexität der Berechnung und Klassifizierung des zu analysierenden Punktmusters abhängt. In der Rechenebene 32 wird eine 27-dimensionale Anordnung von nicht notwendigerweise zusammenhängenden Raumbereichen gebildet, die räumlich komplexe Entscheidungsbereiche bilden.

Zur geometrischen Interpretation der Arbeitsweise der Rechenebene 32 des neuronalen Netzwerkes NN1 sei anhand der Figur 6 eine Anordnung von derartigen Raumbereichen in Form von Hypersphären in einem zweidimensionalen Raum dargestellt. In Figur 6 ist hierzu nach rechts eine erste Komponente E1 des Eingabevektors, und nach oben eine zweite Komponente E2 des Eingabevektors aufgetragen. Innerhalb der Rechenebene 32 werden aus den zweidimensionalen Komponenten E1 und E2 des Eingabevektors Hypersphären (im dargestellen zweidimensionalen Fall einfach Kreise) gebildet, deren Mittelpunkte die hier zweidimensionalen Koordinaten des Eingabevektors darstellen, und deren Kreisflächen (im allgemeinen Fall Raumbereiche) aus den aufgrund des Trainings vorgegebenen Werten entsprechend der gewünschten Klassifizierung gebildet sind. Gemäß Figur 6 sind der Einfachheit halber lediglich zwei Klassen A und B mit den entsprechenden zugehörenden Raumbereichen schematisch dargestellt. Beispielsweise sind Kreise bzw. Raumbereiche 34, 35, 36, 37, 38 dargestellt, die der Klasse A zuzuordnen sind, und Kreise bzw. Raumbereiche 39, 40, 41, 42, 43, die der Klasse B zugeordnet werden. Die Anordnung der Raumbereiche, d.h. deren Mittelpunkte und deren jeweilige Ausdehnung im Raum unter Berücksichtigung der Zuordnung zu einer bestimmten Klasse wird nach dem Training des neuronalen Netzwerkes anhand ausgewählter Beispielmuster festgelegt. Hierbei können die zu einer bestimmten Klasse gehörenden Raumbereiche untereinander ohne weiteres überlappend ausgebildet sein. In der Rechenebene 32 des neuronalen Netzwerkes NN1 wird der in der Eingabeebene 31 eingegebene 27-dimensionale Eingabevektor dahingehend bewertet, zu welcher Anordnung von Hypersphären, bezogen auf eine bestimmte Klasse, er gehört. Falls eine solche Zuordnung zu einer bestimmten Klasse gelingt, wird in der der Rechenebene 32 zugeordneten Ausgabeebene 33 die entsprechend ermittelte Klasse ausgegeben. Die Zahl der Ausgänge Z1 und Z2 der Ausgabeebene 33 entspricht im wesentlichen der Zahl der vorgegebenen Klassen. Bei der schematischen Erläuterung gemäß den Figuren 5 und 6 sind lediglich zwei Klassen A und B und entsprechend zwei Ausgabeelemente Z1 und Z2 der Ausgabeebene 33 dargestellt; in Wirklichkeit beträgt die Anzahl der Klassen bzw. die Anzahl der Ausgabeelemente mehr als etwa 70.

Die in der Rechenebene 32 verarbeiteten Raumbereiche um jeden Vektor des n-dimensionalen Merkmalsraumes müssen nicht notwendigerweise eine kugelförmige beziehungsweise radialsymmetrische Form besitzen, sondern können auch quaderförmig sein, wie dies in der schematischen, auf zwei Dimensionen beschränkte Darstellung nach Figur 7A und Figur 7B gezeigt ist. Diese Figur dient gleichzeitig der näheren Erläuterung der Anpassung der Raumbereiche bei dem Training des neuronalen Netzwerkes. Figur 7A zeigt den Fall, daß sich die jeweils zu den Klassen A und B gehörenden Raumbereiche 44 und 45 der Eingabevektoren 46 und 47 nicht überlappen. In diesem Fall ist eine eindeutige Zuordnung eines an der Eingabeebene 31 des neuronalen Netzwerkes anliegenden Testvektors zu einer bestimmten Klasse A oder B möglich. Demgegenüber zeigt Figur 7B den Fall zweier sich überlappender Raumbereiche 48 und 49; in diesem Fall sind bei der Trainingsprozedur des neuronalen Netzwerkes innerhalb der Rechenebene 32 die den Vektoren 50 und 51 geordneten Raumbereiche 48 und 49 soweit anzupassen, d.h. zu verjüngen, daß keine Überlappung mehr vorliegt.

Zu 3. Zweite Analyse eines fehlerbehafteten physikalischen Blocks hinsichtlich Fehler mit geringer Fehlermasse anhand eines zweiten neuronalen Netzwerks.

Ergibt die Analyse eines fehlerbehafteten physikalischen Blockes durch das erste neuronale Netz NN1 gemäß dem Schritt S4 nach Figur 4, daß ein sogenanntes nicht-massives Ausfallmuster vorliegt, welches das erste neuronale Netzwerk NN1 als solchen Fehlertypus ohne ins einzelne gehende Klassifizierung erkennt, so wird zur genaueren Klassifizierung des Ausfallmusters ein zweites neuronales Netzwerk NN2 verwendet.

Im Gegensatz zur Analyse massereicher Fehler, bei der die Komponenten des Eingabevektors für das erste neuronale Netzwerk NN1 sozusagen durch globale Betrachtung der gesamten Wort- und Bitleitungszähler gewonnen werden, wird bei dem Verfahrensabschnitt NN2 eine Segmentierung der Zähler durchgeführt. Hierzu werden die Wortleitungs- und Bitleitungszähler eines physikalischen Blockes hinsichtlich leitungsorientierter Ausfälle sowie hinsichtlich Punktdefekten und Clustern näher untersucht. Gesucht wird jeweils der Zähler mit den meisten ausfallenden Zellen. Im Falle zweier gleichstarker Ausfälle sowohl in Wortleitungs-, als auch in Bitleitungsrichtung wird der Ausfall in Bitleitungsrichtung zuerst behandelt. Ist das zweite neuronale Netzwerk NN2 in der Lage, alleine aufgrund der Bitleitungsinformation eine eindeutige Klassifikation des Ausfalles durchzuführen, so geschieht dies, ohne Informationen aus den Wortleitungszählern hinzuzuziehen (diese sind beispielsweise auf Dummy-Werte -1 gesetzt), andernfalls werden aus einzelnen Gruppen von Wortleitungszählern zusätzliche Komponenten des Eingabevektors für das zweite neuronale Netzwerk gewonnen, und es wird der gesamte Eingabevektor dem Netzwerk NN2 zur Beurteilung vorgelegt. Dies geschieht sukzessive solange, bis das zweite neuronale Netzwerk NN2 entweder für die kombinierte Information aus Wortleitungs- und Bitleitungsrichtung eine aufgrund des Trainings gelernte Fehlerklasse zuordnen kann, oder keine Information mehr aus der Wortleitungsrichtung vorhanden ist. In diesem Falle wird ein nicht näher klassifizierbarer Ausfalltyp ausgegeben.

Die Komponenten für den insbesondere 19-dimensionalen Eingabevektors für das zweite neuronale Netzwerk werden aus den folgenden Werten ermittelt:
- Achsenindex zur Anzeige der untersuchten Zählerachse: beispielsweise Wert 1 für Wortleitung, Wert -1 für Bitleitung.
- Anzahl der Ausfallbits der untersuchten Ausfallkoordinate.
- Anzahl der benachbarten fehlerbehafteten Zähler.
- Anzahl der fehlerbehafteten Bits in der Gesamtgruppe.
- Anzahl der fehlerbehafteten Bits in einer ersten Nachbargruppe.
- Anzahl der fehlerbehafteten Bits in einer zweiten Nachbargruppe.
- Anzahl der fehlerbehafteten Bits in einer dritten Nachbargruppe.
- Dominanter Ausfalltyp auf der untersuchten Zählerachse: beispielsweise -1 für beide, 0 für Null-, 1 für Einsausfall.
- Echo vorhanden: wird auf Wert 1 gesetzt, falls ein Echo im korrespondierenden physikalischen Block vorhanden ist.
- Echoausfall: wird auf den Wert 1 gesetzt, wenn entweder die erste oder die letzte Leitung fehlerbehaftet ist.
- Kreuzfehler: wird auf den Wert 1 gesetzt, falls eine Singularität auf der untersuchten Leitung gefunden wird.
- Fluktuation auf komplementärem Zähler.
- Anzahl der fehlerbehafteten Bits auf der Leitung mit den meisten Ausfällen des komplementären Zählers.
- Anzahl von hierzu benachbarten fehlerbehafteten Zählern mit Ausfallbits.
- Anzahl von Fehlerbits in dieser Gruppe
- Abstand von dieser ersten zu einer zweiten Leitung mit den zweithäufigsten Ausfällen des komplementären Zählers, falls dieser Abstand < 4 ist, werden die folgenden zusätzlichen Komponenten des Eingabevektors erzeugt, ansonsten werden deren Werte auf -1 eingestellt.
- Anzahl der Ausfallbits auf dieser zweiten Leitung.
- Anzahl der benachbarten fehlerbehafteten Zähler mit Ausfallbits.
- Anzahl der Ausfallbits in dieser Gruppe.

Das oben beschriebene Vorgehen für die Bitleitungsrichtung gilt analog für die Wortleitungsrichtung, falls der massivere der beiden Ausfälle in der Wortleitungsrichtung gefunden wird.

In diesem Programmteil NN2 werden erkannte Fehlerklassen aus den Zählern eliminiert und der beschriebene Algorithmus solange fortgesetzt, bis keine Fehler mehr zur Klassifikation im physikalischen Block übrig sind. Falls beispielsweise die Fehlerklassen MSB (Many Single Bits = viele Einzelbits), MDB (Many Double Bits = viele Doppelbits) oder MCL (Many Clusters = viele Cluster) klassifiziert werden, findet keine Elimination der einzelnen Fehler statt und die Klassifikation des physikalischen Blocks wird als abgeschlossen betrachtet.

Zu 4. Überprüfung, ob signifikante Verteilungen einzelner Fehlerklassen auf bestimmten Waferbereichen vorliegen und gleichzeitiges Erstellen der Ergebnisdatei.

Nach Untersuchung sämtlicher Chips auf dem Wafer kann die Untersuchung eventuell vorhandener, spezieller Verteilungen von Fehlerklassen über den gesamten Wafer vorgenommen werden. Einem dritten neuronalen Netzwerk werden hierzu 22 verschiedene Verteilungen von Ausfallmustern auf dem Wafer trainiert, die beispielsweise folgende Topografien umfassen können: Häufung fehlerhafter Chips über den gesamten Rand des Wafers, auf dem linken oder rechten Rand des Wafers, Häufung fehlerhafter Chips im oberen/unteren und oberen/unteren seitlichen Randbereich des Wafers, Häufung fehlerhafter Chips im Bereich des Flat oder Antiflat des Wafers, Häufung fehlerhafter Chips in einem mittleren Ringbereich des Wafers, und dergleichen.

Zwar auffällige, jedoch nicht vom Netz speziell gelernte Verteilungen werden von dem dritten neuronalen Netzwerk mit einem Fragezeichen klassifiziert. Es handelt sich dabei in der Regel entweder um besonders massiv auftretende Fehlerklassen über den gesamten Wafer oder um massive Clusterungen von Fehlern einer Fehlerklasse, wie sie beispielsweise durch Mißhandlung (Kratzer) auf den Wafern hervorgerufen werden.

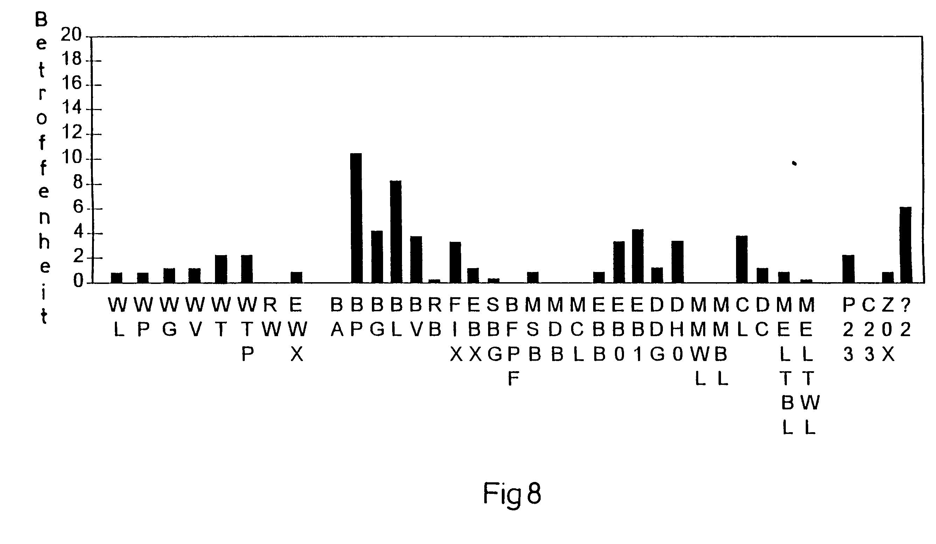

Durch die erfindungsgemäße Vorrichtung bzw. durch das erfindungsgemäße Verfahren gelingt es, unter Verwendung wenigstens eines neuronalen Netzwerkes die Ausfallmuster eines Halbleiterspeicherchips mit hoher Zuverlässigkeit und Reproduzierbarkeit, und vor allem bei geringen Analysezeiten zu klassifizieren. In der Figur 8 ist schematisch das auf einen gesamten Wafer bezogene Ergebnis einer solchen Klassifikation dargestellt, wobei nach rechts die Fehlerklassen aufgetragen sind, und nach oben in Histogrammbalken die jeweilige Häufigkeit zu den Klassen angegeben ist. Eine solche Klassifizierung ermöglicht den mit der Herstellung von Halbleiterspeicherchips befaßten Fachleuten, aussagekräftige Hinweise auf die den Ausfällen zugrunde liegenden Technologieprobleme bei der Herstellung der Halbleiterspeicher zu finden.

### Bezugszeichenliste

- 1: Waferprober
- 2: Meßsondeneinrichtung
- 3: Meßspitzen
- 4: Wafer
- 5: Meßinstrumente
- 6: Steuerprozessor
- 7: Fail Memory
- 8: Daten- und Adressbus
- 9: Schnittstelle
- 10: Rechner
- 11: Bildschirm
- 12: Datenspeicher
- 13: Leitungen
- 14: physikalischer Block
- 15: Einzelbitausfall
- 16: Einzelbitausfall
- 17: Einzelbitausfall
- 18: paarweiser Bitausfall
- 19: paarweiser Bitausfall
- 20: Wortleitungsausfall
- 21: Wortleitungsausfall
- 22: Wortleitungsausfall
- 23: Wortleitungsausfall
- 24: gesonderter Einzelausfall
- 25: Anhäufung nebeneinanderliegender Ausfallzellen
- 26: Ausfall mehrerer nebeneinanderliegender Bitleitungen
- 27: Ausfall von Speicherzellen in einem zusammenhängenden Teil einer Bitleitung oder der vollständigen Bitleitung
- 28: Ausfall von Speicherzellen in einem zusammenhängenden Teil einer Bitleitung oder der vollständigen Bitleitung
- 29: Zweig
- 30: Abschnitt
- 31: Eingabeebene
- 32: Rechenebene
- 33: Ausgabeebene
- 34: Raumbereich (Klasse A)
- 35: Raumbereich (Klasse A)
- 36: Raumbereich (Klasse A)
- 37: Raumbereich (Klasse A)
- 38: Raumbereich (Klasse A)
- 39: Raumbereich (Klasse B)
- 40: Raumbereich (Klasse B)
- 41: Raumbereich (Klasse B)
- 42: Raumbereich (Klasse B)
- 43: Raumbereich (Klasse B)
- 44: Raumbereich des Eingabevektors A
- 45: Raumbereich des Eingabevektors B
- 46: Eingabevektor A
- 47: Eingabevektor B
- 48: sich überlappender Raumbereich
- 49: sich überlappender Raumbereich
- 50: Vektor
- 51: Vektor
- E1 ... E27: Komponenten des Eingabevektors
- NN1: erstes neuronales Netzwerk
- NN2: zweites neuronales Netzwerk
- X1 ... X27: Verarbeitungselemente der Eingabeebene
- Y1 ... Ym: Verärbeitungselemente der Rechenebene
- Z1, Z2: Verarbeitungselemente der Ausgabeebene
- SZ1 ... SZ1024: Spaltenzähler
- ZZ1 ... ZZ256: Zeilenzähler
- BL1 ... BL1024: Bitleitungen
- WL1 ... WL256: Wortleitungen

## Patentansprüche

1. Vorrichtung zur Erfassung und Bewertung eines in einem mehrdimensionalen Koordinatensystem angeordneten räumlich diskreten Punktmusters, wobei jeder Punkt des Musters wenigstens zwei unterscheidbare Zustandswerte annimmt, welche Vorrichtung aufweist:
- eine Meßeinrichtung (1, 2, 3, 5, 6) zum Aufzeichnen der Koordinatenwerte und Zustandswerte jedes Punktes des mehrdimensionalen räumlichen Punktmusters,
- einen Speicher (7) zum Abspeichern von Daten, die den aufgezeichneten Koordinaten- und Zustandswerten jedes Punktes des mehrdimensionalen räumlichen Punktmusters entsprechen,
- einen dem Speicher (7) zugeordneten Rechner (6, 10), in den die abgespeicherten Daten eingegeben werden, und in welchem 'ein Koordinatenzähler (SZ1 - SZ1024, ZZ1 - ZZ256) für jeden Koordinatenwert einer Koordinatenachse aus den gespeicherten Daten bestimmt wird, wobei der Wert des Koordinatenzählers (SZ1 - SZ1024, ZZ1 - ZZ256) aus der Anzahl der erfaßten Punkte dieser Koordinate mit einem vorbestimmten Zustandswert gebildet wird,
- ein dem Rechner (6, 10) zugeordnetes neuronales Netzwerk (NN1, NN2), in den ein n-dimensionaler Eingabevektor mit aus den berechneten Koordinatenzählern (SZ1 - SZ1024, ZZ1 - ZZ256) jedes Punktes des räumlich diskreten Punktmusters gebildeten Komponenten (E1 - E27) eingegeben wird, welches durch Vergleichen des berechneten Eingabevektors des gemessenen Punktmusters mit abgespeicherten, auf der Grundlage von Beispielpunktmustern gewonnenen Vorgabevektoren einen Ausgabevektor berechnet, und einen Klassifikationswert des gemessenen Punktmusters anhand des ermittelten Ausgabevektors zuordnet und ausgibt.

2. Vorrichtung nach Anspruch 1, dadurch gekennzeichnet, daß das neuronale Netzwerk (NN1, NN2) drei Berechnungsebenen (31, 32, 33) besitzt, insbesondere eine dem Eingabevektor zugeordnete Eingabeebene (31), eine dem Ausgabevektor zugeordnete Ausgabeebene (33), und eine zwischen der Eingabeebene (31) und der Ausgabeebene (33) ängeordnete Rechenebene (32).

3. Vorrichtung nach Anspruch 1 oder 2, dadurch gekennzeichnet, daß in der Rechenebene des neuronalen Netzwerkes (NN1, NN2) n-dimensionale Raumbereiche definiert werden, deren Mittelpunkte aus den Komponenten eines Eingabevektors und deren Volumen aus der dem betreffenden Eingabevektor zugeordneten Klassifizierung berechnet wird.

4. Vorrichtung nach Anspruch 1 bis 3, dadurch gekennzeichnet, daß das neuronale Netzwerk (NN1, NN2) eine Anordnung vom Typ des Restricted Coulomb Energy-Netzwerkes aufweist.

5. Verfahren zur Erfassung und Bewertung eines in einem mehrdimensionalen Koordinatensystem angeordneten räumlich diskreten Punktmusters, wobei jeder Punkt des Musters wenigstens zwei unterscheidbare Zustandswerte annimmt, mit den Schritten:
- Aufzeichnen der Koordinatenwerte und Zustandswerte jedes Punktes des mehrdimensionalen räumlichen Punktmusters vermittels einer Meßeinrichtung (1, 2, 3, 5, 6),
- Abspeichern von Daten, die den aufgezeichneten Koordinaten- und Zustandswerten jedes Punktes des mehrdimensionalen räumlichen Punktmusters entsprechen, in einen Speicher (7),
- Eingeben der abgespeicherten Daten in einen dem Speicher zugeordneten Rechner (10),
- Bestimmen eines Koordinatenzählers (SZ1 - SZ1024, ZZ1 - ZZ256) für jeden Koordinatenwert einer Koordinatenachse aus den gespeicherten Daten vermittels des Rechners (10), wobei der Wert des Koordinatenzählers (SZ1 - SZ1024, ZZ1 - ZZ256) aus der Anzahl der erfaßten Punkte dieser Koordinate mit einem vorbestimmten Zustandswert gebildet wird,
- Bilden von n Komponenten eines n-dimensionalen Eingabevektors aus den berechneten Koordinatenzählern (SZ1 - SZ1024, ZZ1 - ZZ256) jedes Punktes des räumlich diskreten Punktmusters,
- Eingeben des n-dimensionalen Eingabevektors in ein neuronales Netzwerk (NN1, NN2),
- Berechnen und Ausgeben eines Ausgabevektors vermittels des neuronalen Netzwerkes (NN1, NN2) durch Vergleichen des berechneten Eingabevektors des gemessenen Punktmusters mit abgespeicherten, auf der Grundlage von Beispielpunktmustern gewonnenen Vorgabevektoren, und
- Zuordnen und Ausgeben eines Klassifikationswertes des gemessenen Punktmusters anhand des vermittels des neuronalen Netzwerkes (NN1, NN2) ermittelten Ausgabevektors.

6. Vorrichtung bzw. Verfahren nach Anspruch 1 bis 5, dadurch gekennzeichnet, daß jeweils einem der n Komponenten des n-dimensionalen Eingabevektors folgende numerischen Werte zugeordnet werden:
- eine Abweichung vom Schwerpunkt von Punkten mit einem vorbestimmten Zustandswert in Richtung einer bestimmten Koordinatenachse, und/oder
- eine Maßzahl für eine globale monotone Verteilung von Teilbereichen des Punktmusters von Punkten mit einem vorbestimmten Zustandswert, und/oder
- eine Maßzahl für die Periodizität des Punktmusters von Punkten mit einem vorbestimmten Zustandswert, und/oder
- ein zweites Moment der Massenverteilung von Punkten des Punktmusters mit einem vorbestimmten Zustandswert.

7. Vorrichtung bzw. Verfahren nach Anspruch 1 bis 6, dadurch gekennzeichnet, daß jeweils einem der n Komponenten des n-dimensionalen Eingabevektors folgende numerischen Werte zugeordnet werden:
- einen Anteil von Koordinatenwerten mit mehr als einer vorbestimmten Anzahl von Punkten des Punktmusters mit einem vorbestimmten Zustandswert, und/oder
- einen Anteil von Echopunkten von Punkten des Punktmusters mit einem vorbestimmten Zustandswert, und/oder
- eine Maßzahl der Fluktuationen von Punkten benachbarter Koordinatenwerte des Punktmusters mit einem vorbestimmten Zustandswert, und/oder
- einen Anteil von Koordinaten mit weniger als eine vorbestimmte Anzahl der entsprechenden Koordinate von Punkten des Punktmusters mit einem vorbestimmten Zustandswert.

8. Vorrichtung bzw. Verfahren nach Anspruch 1 bis 7, dadurch gekennzeichnet, daß jeweils einem der n Komponenten des n-dimensionalen Eingabevektors folgende numerischen Werte zugeordnet werden:
- eine Äquidistanz von Punkten des Punktmusters mit einem vorbestimmten Zustandswert in einem periodischen Teilbereich des Punktmusters, und/oder
- eine Anzahl von zusammenhängenden oder wenigstens teilweise zusammenhängenden Teilbereichen von Punkten des Punktmusters mit einem vorbestimmten Zustandswert in vorbestimmten Koordinatenrichtungen.

9. Vorrichtung bzw. Verfahren nach Anspruch 1 bis 8, dadurch gekennzeichnet, daß die den n Komponenten des n-dimensionalen Eingabevektors zugeordneten numerischen Werte normiert werden, insbesondere in dem numerischen Zahlenbereich zwischen-1 und +1.

10. Vorrichtung bzw. Verfahren nach Anspruch 1 bis 9, dadurch gekennzeichnet, daß das mehrdimensionale Koordinatensystem des räumlich diskreten Punktmusters orthogonale Koordinatenachsen, insbesondere zwei orthogonale Koordinatenachsen aufweist, und der Wert jedes Koordinatenzählers (SZ1 - SZ1024, ZZ1 - ZZ256) durch Aufsummierung der erfaßten Punkte jeder Koordinate mit einem vorbestimmten Zustandswert und Projektion auf die entsprechende orthogonale Koordinatenachse, insbesondere Spaltenachse und Reihenachse gebildet wird.

11. Vorrichtung bzw. Verfahren nach Anspruch 1 bis 10, dadurch gekennzeichnet, daß das Punktmuster das Ausfallmuster eines physikalisch zusammenhängenden Blockes von Speicherzellen eines Halbleiterspeichers von einer Vielzahl auf der Hauptoberfläche eines Halbleiterwafers (4) ausgebildeten Halbleiterspeichern darstellt.

12. Vorrichtung bzw. Verfahren nach Anspruch 11, dadurch gekennzeichnet, daß jeder Punkt des Ausfallmusters einen von drei Zustandswerten besitzt, von denen ein Zustandswert einem Null-Ausfall der Speicherzelle, ein Zustandswert einem Eins-Ausfall der Speicherzelle und ein Zustandswert einem Null- und Eins-Ausfall der Speicherzelle zugeordnet ist.

13. Vorrichtung bzw. Verfahren nach Anspruch 11 oder 12, dadurch gekennzeichnet, daß der Halbleiterspeicher einen 4 MBit-Speicher mit physikalisch zusammenhängenden Speicherblöcken (14) von jeweils 256 Zeilen und 1024 Spalten darstellt.

14. Vorrichtung bzw. Verfahren nach Anspruch 11 bis 13, dadurch gekennzeichnet, daß die Speicherzellen des auf der Hauptoberfläche des Halbleiterwafers (4) ausgebildeten Halbleiterspeichers in Bitleitungen (BL1 - BL1024) bzw. Spalten und in Zeilen bzw. Wortleitungen (WL1 - WL256) matrixförmig angeordnet sind, und die Koordinatenzähler einen Spaltenzähler (SZ1 - SZ1024) und einen Zeilenzähler (ZZ1 - ZZ256) aufweisen.

15. Vorrichtung bzw. Verfahren nach Anspruch 11 bis 14, dadurch gekennzeichnet, daß den Komponenten des n-dimensionalen Eingabevektors folgende numerischen Werte zugeordnet werden:
- eine Abweichung vom Schwerpunkt von Ausfallzellen eines physikalischen Blockes (14) des Halbleiterspeichers mit einem vorbestimmten Ausfallzustand in Bitleitungs- und/oder Wortleitungsrichtung; und/oder
- ein zweites Moment der Massenverteilung von Ausfallzellen eines physikalischen Blockes (14) des Halbleiterspeichers mit einem vorbestimmten Ausfallzustand in Bitleitungs- und/oder Wortleitungsrichtung; und/oder
- eine Maßzahl der globalen monotonen Verteilung von Ausfallzellen eines physikalischen Blockes (14) des Halbleiterspeichers mit einem vorbestimmten Ausfallzustand; und/oder
- eine Maßzahl für die Periodizität des Ausfallmusters von Ausfallzellen eines physikalischen Blockes (14) des Halbleiterspeichers mit einem vorbestimmten Ausfallzustand.

16. Vorrichtung bzw. Verfahren nach Anspruch 11 bis 15, dadurch gekennzeichnet, daß den Komponenten des n-dimensionalen Eingabevektors folgende numerischen Werte zugeordnet werden:
- ein Anteil der Bitleitungen (BL1 - BL1024) und/oder Wortleitungen (WL1 - WL256) von Ausfallzellen eines physikalischen Blockes (14) des Halbleiterspeichers mit einem vorbestimmten Ausfallzustand mit mehr als einem vorgegebenen ersten Grenzwert auf der betroffenen Leitung; und/oder
- einen Anteil von Bitleitungen (BL1 - BL1024) und/oder Wortleitungen (WL1 - WL256) von Ausfallzellen eines physikalischen Blockes (14) des Halbleiterspeichers mit einem vorbestimmten Ausfallzustand mit mehr als einem vorgegebenen zweiten Grenzwert auf der betroffenen Leitung, wobei die betroffenen Wort- (WL1 - WL256) und/oder Bitleitungen (BL1 - BL1024) ein Echo in benachbarten physikalischen Blöcken aufweisen; und/oder
- eine Maßzahl für die Fluktuationen von Ausfallzellen eines physikalischen Blockes (14) des Halbleiterspeichers mit einem vorbestimmten Ausfallzustand zwischen benachbärten Bitleitungen (BL1 - BL1024) und/oder benachbarten Wortleitungen (WL1 - WL256); und/oder
- einen Anteil von Bitleitungen (BL1 - BL1024) und/oder Wortleitungen mit Ausfallzellen eines physikalischen Blockes (14) des Halbleiterspeichers mit einem vorbestimmten Ausfallzustand mit weniger als einem dritten Grenzwert von Ausfallbits auf der betroffenen Wort- (WL1 - WL256) und/oder Bitleitung (BL1 - BL1024); und/oder
- eine Maßzahl für die Äquidistanz ausfallbehafteter Bitleitungen (BL1 - BL1024) und/oder Wortleitungen (WL1 - WL256) mit einem periodischen Muster;
- eine Maßzahl für die Anzahl von größeren Gruppen von Ausfallzellen in Bitleitungs- und/oder Wortleitungsrichtung; und/oder
- einen Anteil von Bitleitungen (BL1 - BL1024) und/oder Wortleitungen (WL1 - WL256), welche Zwischenschichtkurzschlüsse in Bit- und/oder Wortleitungsrichtung aufweisen; und/oder
- die Gesamtzahl von Ausfallzellen; und/oder
- eine Maßzahl für am Randbereich des Wafers (4) gehäuft auftretende Ausfallzellen; und/oder
- ein Verhältnis zwischen längeren ausfallbedingten Wort-(WL1 - WL256) und/oder Bitleitungen (BL1 - BL1024) in Wortleitungs- und/oder Bitleitungsrichtung.

17. Vorrichtung bzw. Verfahren nach Anspruch 11 bis 16, dadurch gekennzeichnet, daß sämtliche Halbleiterspeicher eines Wafers (4) vermittels der Meßeinrichtung (1, 2, 3, 5, 6) gemessen und untersucht werden, und das neuronale Netzwerk (NN1, NN2) aus den berechneten Ausgabevektoren der Daten von allen physikalischen Blöcken (14) bzw. allen Speicherchips eine auf den gesamten Wafer (4) bezogene Klassifikation von Speicherzellenausfallmustern ausgibt.

18. Vorrichtung bzw. Verfahren nach Anspruch 17, dadurch gekennzeichnet, daß zum Trainieren des neuronalen Netzwerkes (NN1, NN2) zu einer auf den gesamten Wafer (4) bezogenen Klassifikation von Speicherzellenausmustern vorbestimmte Waferverteilungen vorgesehen werden, bei denen das Ausfallmuster von physikalischen Blöcken (14) der Speicherzellen an ausgewählten Bereichen auf der Oberfläche des Wafers (4) gehäuft ausgebildet sind.

## Claims

1. Apparatus for acquiring and assessing a spatially discrete point pattern arranged in a multidimensional coordinate system, each point of the pattern assuming at least two distinguishable state values, which apparatus has:
- a measuring device (1, 2, 3, 5, 6) for recording the coordinate values and state values of each point of the multidimensional spatial point pattern,
- a memory (7) for storing data which correspond to the recorded coordinate and state values of each point of the multidimensional spatial point pattern,
- a computer (6, 10), which is assigned to the memory (7) and into which the stored data are input, and in which a coordinate counter (SZ1 - SZ1024, ZZ1 - ZZ256) is determined for each coordinate value of a coordinate axis from the stored data, the value of the coordinate counter (SZ1 - SZ1024, ZZ1 - ZZ256) being formed from the number of acquired points of this coordinate with a predetermined state value,
- a neural network (NN1, NN2), which is assigned to the computer (6, 10) and into which is input an n-dimensional input vector with components (E1 - E27) formed from the calculated coordinate counters (SZ1 - SZ1024, ZZ1 - ZZ256) of each point of the spatially discrete point pattern, which calculates an output vector by comparing the calculated input vector of the measured point pattern with stored predefined vectors obtained on the basis of exemplary point patterns, and assigns and outputs a classification value of the measured point pattern using the output vector determined.

2. Apparatus according to Claim 1, characterized in that the neural network (NN1, NN2) has three calculation levels (31, 32, 33), in particular an input level (31) assigned to the input vector, an output level (33) assigned to the output vector, and a computation level (32) arranged between the input level (31) and the output level (33).

3. Apparatus according to Claim 1 or 2, characterized in that n-dimensional space regions are defined in the computation level of the neural network (NN1, NN2), the centre points of which regions are calculated from the components of an input vector and the volume of which regions is calculated from the classification assigned to the relevant input vector.

4. Apparatus according to Claims 1 to 3, characterized in that the neural network (NN1, NN2) has an arrangement of the restricted coulomb energy network type.

5. Method for acquiring and assessing a spatially discrete point pattern arranged in a multidimensional coordinate system, each point of the pattern assuming at least two distinguishable state values, having the following steps:
- recording of the coordinate values and state values of each point of the multidimensional spatial point pattern by means of a measuring device (1, 2, 3, 5, 6),
- storage of data which correspond to the recorded coordinate and state values of each point of the multidimensional spatial point pattern, in a memory (7),
- inputting of the stored data into a computer (10), which is assigned to the memory,
- determination of a coordinate counter (SZ1
- SZ1024, ZZ1 - ZZ256) for each coordinate value of a coordinate axis from the stored data by means of the computer (10), the value of the coordinate counter (SZ1 - SZ1024, ZZ1 - ZZ256) being formed from the number of acquired points of this coordinate with a predetermined state value,
- formation of n components of an n-dimensional input vector from the calculated coordinate counters (SZ1 - SZ1024, ZZ1 - ZZ256) of each point of the spatially discrete point pattern.
- inputting of the n-dimensional input vector into a neural network (NN1, NN2),
- calculation and outputting of an output vector by means of the neural network (NN1, NN2) by comparing the calculated input vector of the measured point pattern with stored predefined vectors obtained on the basis of exemplary point patterns, and
- assignment and outputting of a classification value of the measured point pattern using the output vector determined by means of the neural network (NN1, NN2).

6. Apparatus and/or method according to Claims 1 to 5, characterized in that the following numerical values are assigned in each case to one of the n components of the n-dimensional input vector:
- a deviation from the centre of gravity of points with a predetermined state value in the direction of a specific coordinate axis, and/or
- a dimension figure for a global monotonic distribution of partial regions of the point pattern of points with a predetermined state value, and/or
- a dimension figure for the periodicity of the point pattern of points with a predetermined state value, and/or
- a second moment of the mass distribution of points of the point pattern with a predetermined state value.

7. Apparatus and/or method according to Claims 1 to 6, characterized in that the following numerical values are assigned in each case to one of the n components of the n-dimensional input vector.
- a proportion of coordinate values with more than a predetermined number of points of the point pattern with a predetermined state value, and/or
- a proportion of echo points of points of the point pattern with a predetermined state value, and/or
- a dimension figure of the fluctuations of points of adjacent coordinate values of the point pattern with a predetermined state value, and/or
- a proportion of coordinates with fewer than a predetermined number of the corresponding coordinates of points of the point pattern with a predetermined state value.

8. Apparatus and/or method according to Claims 1 to 7, characterized in that the following numerical values are assigned in each case to one of the n components of the n-dimensional input vector:
- an equidistance of points of the point pattern with a predetermined state value in a periodic partial region of the point pattern, and/or
- a number of contiguous or at least partially contiguous partial regions of points of the point pattern with a predetermined state value in predetermined coordinate directions.

9. Apparatus and/or method according to Claims 1 to 8, characterized in that the numerical values assigned to the n components of the n-dimensional input vector are normalized, in particular in the numerical range of numbers between -1 and +1.

10. Apparatus and/or method according to Claims 1 to 9, characterized in that the multidimensional coordinate system of the spatially discrete point pattern has orthogonal coordinate axes, in particular two orthogonal axes, and the value of each coordinate counter (SZ1 - SZ1024, ZZ1 - ZZ256) is formed by formation of the acquired points of each coordinate with a predetermined state value and projection onto the corresponding orthogonal coordinate axis, in particular column axis and row axis.

11. Apparatus and/or method according to Claims 1 to 10, characterized in that the point pattern represents the failure pattern of a physically contiguous block of memory cells of a semiconductor memory from a multiplicity of semiconductor memories formed on the main surface of a semiconductor wafer (4).

12. Apparatus and/or method according to Claim 11, characterized in that each point of the failure pattern has one of three state values, of which one state value is assigned to a zero failure of the memory cell, one state value is assigned to a one failure of the memory cell and one state value is assigned to a zero and one failure of the memory cell.

13. Apparatus and/or method according to Claim 11 or 12, characterized in that the semiconductor memory represents a 4 Mbit memory with physically contiguous memory blocks (14) each of 256 rows and 1024 columns.

14. Apparatus and/or method according to Claims 11 to 13, characterized in that the memory cells of the semiconductor memory formed on the main surface of the semiconductor wafer (4) are arranged in matrix form in bit lines (BL1 - BL1024) or columns, and in rows or word lines (WL1 - WL256) and the coordinate counters have a column counter (SZ1 - SZ1024) and a row counter (ZZ1 - ZZ256).

15. Apparatus and/or method according to Claims 11 to 14, characterized in that the following numerical values are assigned to the components of the n-dimensional input vector:
- a deviation from the centre of gravity of failure cells of a physical block (14) of the semiconductor memory with a predetermined failure state in the bit-line and/or word-line direction; and/or
- a second moment of the mass distribution of failure cells of a physical block (14) of the semiconductor memory with a predetermined failure state in the bit-line and /or word-line direction; and/or
- a dimension figure of the global monotonic distribution of failure cells of a physical block (14) of the semiconductor memory with a predetermined failure state; and/or
- a dimension figure for the periodicity of the failure pattern of failure cells of a physical block (14) of the semiconductor memory with a predetermined failure state.

16. Apparatus and/or method according to Claims 11 to 15, characterized in that the following numerical values are assigned to the components of the n-dimensional input vector:
- a proportion of the bit lines (BL1 - BL1024) and/or word lines (WL1 - WL256) of failure cells of a physical block (14) of the semiconductor memory with a predetermined failure state with more than a predetermined first limit value on the relevant line; and/or
- a proportion of bit lines (BL1 - BL1024) and/or word lines WL1 - WL256) of failure cells of a physical block (14) of the semiconductor memory with a predetermined failure state with more than a predetermined second limit value on the relevant line, the relevant word (WL1 - WL256) and/or bit lines (BL1 - BL1024) having an echo in adjacent physical blocks; and/or
- a dimension figure for the fluctuations of failure cells of a physical block (14) of the semiconductor memory with a predetermined failure state between adjacent bit lines (BL1 - BL1024) and/or adjacent word lines (WL - WL256); and/or
- a proportion of bit lines (BL1 - BL1024) and/or word lines with failure cells of a physical block (14) of the semiconductor memory with a predetermined failure state with less than a third limit value of failure bits on the relevant word (WL1 - WL256) and/or bit line (BL1 - BL1024); and/or
- a dimension figure for the equidistance of failure-affected bit lines (BL1 - BL1024) and/or word lines (WL1 - WL256) with a periodic pattern;
- a dimension figure for the number of relatively large groups of failure cells in the bit-line and/or word-line direction; and/or
- a proportion of bit lines (BL1 - BL1024) and/or word lines (WL1 - WL256) which have interlayer shorts in the bit- and/or word-line direction; and/or
- the total number of failure cells; and/or
- a dimension figure for failure cells occurring in clustered fashion at the edge region of the wafer (4); and/or
- a ratio between relatively long failure-affected word (WL1 - WL256) and/or bit lines (BL1 - BL1024) in the word-line and/or bit-line direction.

17. Apparatus and/or method according to Claims 11 to 16, characterized in that all of the semiconductor memories of a wafer (4) are measured and examined by means of the measuring device (1, 2, 3, 5, 6), and the neural network (NN1, NN2), from the calculated output vectors of the data from all the physical blocks (14) or all the memory chips, outputs a classification of memory cell failure patterns which relates to the entire wafer (4).

18. Apparatus and/or method according to Claim 17, characterized in that, in order to train the neural network (NN1, NN2), with respect to a classification of memory cell failure patterns which relates to the entire wafer (4), predetermined wafer distributions are provided in which the failure pattern of physical blocks (14) of the memory cells is formed in clustered fashion at selected regions on the surface of the wafer (4).

## Revendications

1. Dispositif pour la saisie et l'analyse d'une distribution spatiale de points discrets répartis dans un système de coordonnées à plusieurs dimensions, chaque point de la distribution pouvant prendre au moins deux valeurs d'état différentes, et comportant:
- un dispositif de mesure (1, 2, 3, 5, 6) pour enregistrer les valeurs de coordonnées et les valeurs d'état de chaque point de la distribution spatiale de points discrets à plusieurs dimensions,
- une mémoire (7) pour mémoriser les données qui correspondent aux valeurs de coordonnées et aux valeurs d'état enregistrées pour chaque point de la distribution spatiale de points discrets à plusieurs dimensions,
- un ordinateur (6, 10), associé à la mémoire (7), dans lequel on entre les données mémorisées et avec lequel on détermine, à partir des données mémorisées, un numérateur de coordonnées (SZ1 - SZ1024, ZZ1 - ZZ256) pour chaque valeur de coordonnée d'un axe de coordonnées, la valeur du numérateur de coordonnées (SZ1 - SZ1024, ZZ1 - ZZ256) étant formée à partir du nombre de points de cette coordonnée, qui ont une valeur d'état prédéterminée et qui ont été saisis,
- un réseau neuronal (NN1, NN2), associé à l'ordinateur (6, 10), dans lequel on entre un vecteur d'entrée à n dimensions avec les composantes (E1 - E27), formées à partir des numérateurs de coordonnées calculés (SZ1 - SZ1024, ZZ1 - ZZ256) de chaque point de la distribution spatiale de points discrets, réseau qui calcule un vecteur de sortie, en comparant le vecteur d'entrée calculé de la distribution de défaillances mesurée avec des vecteurs de référence mémorisés, obtenus sur la base de distributions de défaillances prises comme exemples, et qui affecte et sort, à l'aide du vecteur de sortie déterminé, une valeur de classification de la distribution de défaillances mesurée.

2. Dispositif selon la revendication 1 caractérisé par le fait que le réseau neuronal (NN1, NN2) comporte trois couches de calcul (31, 32, 33), en particulier une couche d'entrée (31), affectée au vecteur d'entrée, une couche de sortie (33), affectée au vecteur de sortie, et une couche de calcul (32), placée entre la couche d'entrée (31) et la couche de sortie (33).

3. Dispositif selon la revendication 1 ou 2 caractérisé par le fait que, dans la couche de calcul du réseau neuronal (NN1, NN2), on définit des zones spatiales à n dimensions, dont les centres sont calculés à partir des composantes d'un vecteur d'entrée et dont le volume est calculé à partir de la classification affectée au vecteur d'entrée concerné.

4. Dispositif selon la revendication 1 à 3 caractérisé par le fait que le réseau neuronal (NN1, NN2) comporte une disposition du type de réseau Restricted Coulomb Energy.

5. Procédé pour la saisie et l'analyse d'une distribution spatiale de points discrets répartis dans un système de coordonnées à plusieurs dimensions, chaque point de la distribution pouvant prendre au moins deux valeurs d'état différentes, comportant les étapes:
- enregistrement, au moyen d'un dispositif de mesure (1, 2, 3, 5, 6), des valeurs de coordonnées et des valeurs d'état de chaque point de la distribution spatiale de points discrets à plusieurs dimensions,
- mémorisation, dans une mémoire (7), de données qui correspondent aux valeurs de coordonnées et aux valeurs d'état enregistrées pour chaque point de la distribution spatiale de points discrets à plusieurs dimensions,
- entrée des données mémorisées dans un ordinateur (10) associé à la mémoire,
- détermination, à partir des données mémorisées et au moyen de l'ordinateur (10), d'un numérateur de coordonnées (SZ1 - SZ1024, ZZ1 - ZZ256) pour chaque valeur de coordonnée d'un axe de coordonnées, la valeur du numérateur de coordonnées (SZ1 - SZ1024, ZZ1 - ZZ256) étant formée à partir du nombre de points de cette coordonnée, qui ont une valeur d'état prédéterminée et qui ont été saisis,
- formation, à partir des numérateurs de coordonnées calculés (SZ1 - SZ1024, ZZ1 - ZZ256) de chaque point de la distribution spatiale de points discrets, de n composantes d'un vecteur d'entrée à n dimensions,
- entrée du vecteur d'entrée à n dimensions dans un réseau neuronal (NN1, NN2),
- calcul et sortie, au moyen du réseau neuronal (NN1, NN2), d'un vecteur de sortie, en comparant le vecteur d'entrée calculé de la distribution de défaillances mesurée avec des vecteurs de référence mémorisés, obtenus sur la base de distributions de défaillances prises comme exemples, et
- affectation et sortie, à l'aide du vecteur de sortie déterminé au moyen du réseau neuronal (NN1, NN2), d'une valeur de classification de la distribution de défaillances mesurée.

6. Dispositif et/ou procédé selon l'une des revendications 1 à 5 caractérisés par le fait que les valeurs numériques suivantes sont affectées respectivement à l'une des n composantes du vecteur d'entrée à n dimensions:
- une déviation, en direction d'un axe de coordonnées déterminé, du centre de gravité de points qui ont une valeur d'état prédéterminée, et/ou
- une cote pour une répartition monotone globale de zones partielles de la distribution spatiale de points qui ont une valeur d'état prédéterminée, et/ou
- une cote pour la périodicité de la distribution spatiale de points qui ont une valeur d'état prédéterminée, et/ou
- un deuxième moment de la répartition des masses de points de la distribution qui ont une valeur d'état prédéterminée.

7. Dispositif et/ou procédé selon l'une des revendications 1 à 6 caractérisés par le fait que les valeurs numériques suivantes sont affectées respectivement à l'une des n composantes du vecteur d'entrée à n dimensions:
- une quote-part de valeurs de coordonnées avec un nombre, supérieur à un nombre prédéterminé, de points de la distribution qui ont une valeur d'état prédéterminée, et/ou
- une quote-part de points échos de points de la distribution qui ont une valeur d'état prédéterminée, et/ou
- une valeur des fluctuations de points de valeurs de coordonnées voisines de la distribution de points qui ont une valeur d'état prédéterminée, et/ou
- une quote-part de coordonnées avec un nombre, inférieur à un nombre prédéterminé, de la coordonnée correspondante de points de la distribution qui ont une valeur d'état prédéterminée.

8. Dispositif et/ou procédé selon l'une des revendications 1 à 7 caractérisés par le fait que les valeurs numériques suivantes sont affectées respectivement à l'une des n composantes du vecteur d'entrée à n dimensions:
- une équidistance de points de la distribution qui ont une valeur d'état prédéterminée dans une zone partielle périodique de la distribution de points et/ou
- un nombre de zones partielles cohérentes ou au moins partiellement cohérentes de points de la distribution qui ont une valeur d'état prédéterminée, dans des directions prédéterminées des coordonnées.

9. Dispositif et/ou procédé selon l'une des revendications 1 à 8 caractérisés par le fait que les valeurs numériques affectées aux n composantes du vecteur d'entrée à n dimensions sont normées, en particulier dans la plage numérique comprise entre -1 et +1.

10. Dispositif et/ou procédé selon l'une des revendications 1 à 9 caractérisés par le fait que le système de coordonnées multidimensionnel de la distribution spatiale de points discrets comporte des axes de coordonnées orthogonaux, en particulier deux axes de coordonnées orthogonaux, et que la valeur de chaque numérateur de coordonnées (SZ1 - SZ1024, ZZ1 - ZZ256) est formée par addition des points de chaque coordonnée, saisis et ayant une valeur d'état prédéterminée, et projection sur l'axe de coordonnées orthogonal correspondant, en particulier l'axe des colonnes et l'axe des rangées.

11. Dispositif et/ou procédé selon l'une des revendications 1 à 10 caractérisés par le fait que la distribution de points représente la distribution de défaillances d'un bloc physiquement cohérent de cellules d'une mémoire à semi-conducteurs formée par une pluralité de mémoires à semi-conducteurs sur la surface principale d'une plaquette de semi-conducteur (4).

12. Dispositif et/ou procédé selon la revendication 11 caractérisés par le fait que chaque point de la distribution de défaillances a une de trois valeurs d'état, dont une valeur d'état est affectée à une défaillance de zéro logique de la cellule de mémoire, une valeur d'état est affectée à une défaillance de un logique de la cellule de mémoire et une valeur d'état est affectée à une défaillance de zéro et de un logiques de la cellule de mémoire.

13. Dispositif et/ou procédé selon la revendication 11 ou 12 caractérisés par le fait que la mémoire à semi-conducteurs représente une mémoire de 4 Mbits avec des blocs de mémoire (14) physiquement cohérents de chacun 256 lignes et 1024 colonnes.

14. Dispositif et/ou procédé selon l'une des revendications 11 à 13 caractérisés par le fait que les cellules de mémoire de la mémoire à semi-conducteurs, formée sur la surface principale de la plaquette de semi-conducteur (4), sont disposées, en forme de matrice, en lignes de bits (BL1 - BL1024) et/ou colonnes et en rangées et/ou lignes de mots (WL1 - WL256) et les numérateurs de coordonnées comporte un numérateur de colonnes (SZ1 - SZ1024) et un numérateur de lignes (ZZ1 - ZZ256).

15. Dispositif et/ou procédé selon l'une des revendications 11 à 14 caractérisés par le fait que les valeurs numériques suivantes sont affectées au vecteur d'entrée à n dimensions:
- une déviation, dans la direction des lignes de bits et/ou dans la direction des lignes de mots, du centre de gravité de cellules défaillantes d'un bloc physique (14) de la mémoire à semi-conducteurs qui ont un état de défaillance prédéterminé; et/ou
- un deuxième moment, dans la direction des lignes de bits et/ou dans la direction des lignes de mots, de la répartition des masses de cellules défaillantes d'un bloc physique (14) de la mémoire à semi-conducteurs qui ont un état de défaillance prédéterminé; et/ou
- une cote de la répartition monotone globale de cellules défaillantes d'un bloc physique (14) de la mémoire à semi-conducteurs qui ont un état de défaillance prédéterminé; et/ou
- une cote pour la périodicité de la distribution de défaillances de cellules défaillantes d'un bloc physique (14) de la mémoire à semi-conducteurs qui ont un état de défaillance prédéterminé.

16. Dispositif et/ou procédé selon l'une des revendications 11 à 15 caractérisés par le fait que les valeurs numériques suivantes sont affectées au vecteur d'entrée à n dimensions:
- une quote-part de lignes de bits (BL1 - BL1024) et/ou de lignes de mots (WL1 - WL256) de cellules défaillantes d'un bloc physique (14) de la mémoire à semi-conducteurs qui ont un état de défaillance prédéterminé, cette quote-part étant supérieure à une première valeur seuil prédéterminée sur la ligne concernée; et/ou
- une quote-part de lignes de bits (BL1 - BL1024) et/ou de lignes de mots (WL1 - WL256) de cellules défaillantes d'un bloc physique (14) de la mémoire à semi-conducteurs qui ont un état de défaillance prédéterminé, cette quote-part étant supérieure à une deuxième valeur seuil prédéterminée sur la ligne concernée et les lignes de mots (WL1 - WL256) et/ou les lignes de bits (BL1 - BL1024) concernées comportant un écho dans les blocs physiques voisins; et/ou
- une cote pour les fluctuations de cellules défaillantes d'un bloc physique (14) de la mémoire à semi-conducteurs qui ont un état de défaillance prédéterminé entre des lignes de bits voisines (BL1 - BL1024) et/ou des lignes de mots voisines (WL1
- WL256); et/ou
- une quote-part de lignes de bits (BL1 - BL1024) et/ou de lignes de mots de cellules défaillantes d'un bloc physique (14) de la mémoire à semi-conducteurs qui ont un état de défaillance prédéterminé, cette quote-part étant inférieure à une troisième valeur seuil de bits défaillants sur la ligne de mots (WL1 - WL256) et/ou la ligne de bits (BL1 - BL1024) concernées; et/ou
- une cote pour l'équidistance de lignes de bits (BL1 - BL1024) et/ou de lignes de mots (WL1 - WL256) affectées de défaillances avec une distribution périodique;
- une cote pour le nombre de groupes plus importants de cellules défaillantes dans la direction des lignes de bits et/ou de lignes de mots; et/ou
- une quote-part de lignes de bits (BL1 - BL1024) et/ou de lignes de mots (WL1 - WL256) qui comportent des courts-circuits intercouches dans la direction des lignes de bits et/ou de lignes de mots; et/ou
- le nombre total de cellules défaillantes; et/ou
- une cote pour des cellules défaillantes, apparaissant en groupes, dans la zone de bordure de la plaquette (4); et/ou
- un rapport entre lignes de mots (WL1 - WL256) et/ou lignes de bits (BL1 - BL1024) affectées de défaillances sur une longueur prolongée dans la direction des lignes de mots et/ou de lignes de bits.

17. Dispositif et/ou procédé selon l'une des revendications 11 à 16 caractérisés par le fait que l'ensemble des mémoires à semi-conducteurs d'une plaquette (4) sont mesurées et analysées au moyen d'un dispositif de mesure (1, 2, 3, 5, 6) et que le réseau neuronal (NN1, NN2) sort, à partir des vecteurs de sortie calculés avec les données de tous les blocs physiques (14) et/ou de toutes les puces de mémoire, une classification de distributions de défaillances de cellules de mémoires qui se rapporte à l'ensemble de la plaquette (4).

18. Dispositif et/ou procédé selon la revendication 17 caractérisés par le fait que, pour l'apprentissage du réseau neuronal (NN1, NN2) pour le rendre apte à une classification des distributions de défaillances de cellules de mémoire qui se rapporte à l'ensemble de la plaquette (4), on prévoit des répartitions prédéterminées de plaquettes, dans lesquelles les distributions de défaillances de blocs physiques (14) des cellules de mémoire sont formées par groupes dans des zones sélectionnées de la surface de la plaquette (4).
